# EUROPEAN PATENT APPLICATION

(11) **EP 4 764 777 A1**
(43) Date of publication of application: **24.06.2026**
(21) Application number: 25212126.4
(22) Date of filing: 29.10.2025
(51) Int. Cl.: G06F 1/16, H04M 1/02

(54) **FOLDING SET AND ELECTRONIC DEVICE INCLUDING THE SAME**

(30) Priority: 23.12.2024 KR 20240193793
(71) Applicant: Samsung Display Co., Ltd., Yongin-si, Gyeonggi-do (KR)
(72) Inventor: LEE, Sang Wol, Yongin-si (KR)
(74) Representative: Marks & Clerk LLP

(57) **Abstract**

An electronic device including a display device, a first body and a second body in a first direction under the display device, a bracket between the first body and the second body, a first rotator and a second rotator between the first body and the bracket and between the second body and the bracket, respectively, a first rotation link and a second rotation link facing the first rotator and the second rotator, respectively, in a second direction crossing the first direction, and a plurality of protruding pins protruding from the first rotation link and the second rotation link toward the first rotator and the second rotator, respectively, and in guide grooves defined on surfaces of the first rotator and the second rotator facing the first rotation link and the second rotation link. The guide grooves include first guide groove, and a second guide groove extending from the first guide groove.

## Description

### BACKGROUND

Aspects of some embodiments of the present disclosure described herein relate to a folding set and an electronic device including the same.

An electronic device, which displays images to users, such as a smart phone, a digital camera, a notebook computer, a navigation system, and a smart television includes a display device for displaying the images. The display device generates an image and provides the users with the image through a display screen.

With the recent development of technology of display devices, various types of display devices have been developed. For example, various flexible display devices that may be transformed, folded, or rolled into a curved shape are being developed. Flexible display devices that may have various shapes may be relative easy to carry and may relatively improve user convenience.

A folding display device of a flexible display device may be folded around a folding axis that extends in one direction. The folding display device may be folded by a mechanism, such as a folding set.

The above information disclosed in this Background section is only for enhancement of understanding of the background and therefore the information discussed in this Background section does not necessarily constitute prior art.

### SUMMARY

Embodiments of the present disclosure provide a folding set that may variously vary a shape of a folding area depending on a folding angle of first and second non-folding areas, and an electronic device including the same.

According to some embodiments, an electronic device includes a display device, a first body and a second body arranged in a first direction under the display device, a bracket between the first body and the second body, a first rotator and a second rotator between the first body and the bracket and between the second body and the bracket, respectively, and coupled to the bracket to be rotatable, a first rotation link and a second rotation link facing the first rotator and the second rotator, respectively, in a second direction crossing the first direction, and coupled to the bracket to be rotatable, and a plurality of protruding pins protruding from the first rotation link and the second rotation link toward the first rotator and the second rotator, respectively, and located in guide grooves defined on surfaces of the first rotator and the second rotator facing the first rotation link and the second rotation link, and each of the guide grooves includes a first guide groove, and a second guide groove extending from the first guide groove in another direction.

According to some embodiments, an electronic device includes a display device, a first body and a second body arranged in a first direction under the display device, a bracket between the first body and the second body, a first rotator and a second rotator between the first body and the bracket and between the second body and the bracket, respectively, and coupled to the bracket to be rotatable, a first rotation link and a second rotation link facing the first rotator and the second rotator, respectively, in a second direction crossing the first direction, and coupled to the bracket to be rotatable, a plurality of protruding pins protruding from the first rotation link and the second protruding link in the second direction, and a plurality of protruding side walls protruding from one side of the first body and one side of the second body facing each other in the first direction, and facing the first rotation link and the second rotation link in the second direction, the protruding pins protrude toward the protruding side walls, and are located in guide grooves defined on surfaces of the protruding side walls facing the first rotation link and the second rotation link, and each of the guide grooves includes a first guide groove, and a second guide groove extending from the first guide groove in another direction.

According to some embodiments, a folding set includes a first body and a second body arranged in a first direction, a bracket between the first body and the second body, a first rotator and a second rotator between the first body and the bracket and between the second body and the bracket, respectively, and coupled to the bracket to be rotatable, a first rotation link and a second rotation link facing the first rotator and the second rotator, respectively, in a second direction crossing the first direction, and coupled to the bracket to be rotatable, and a plurality of protruding pins protruding from the first rotation link and the second rotation link toward the first rotator and the second rotator, respectively, and located in guide grooves defined on surfaces of the first rotator and the second rotator facing the first rotation link and the second rotation link, and each of the guide grooves includes a first guide groove extending in the first direction, and a second guide groove extending from the first guide groove toward a lower side of an inside of the bracket, and extending to form an angle of more than 90 degree and less than 180 degrees with respect to the first guide groove.

At least some of the above and other features of the invention are set out in the claims.

### BRIEF DESCRIPTION OF THE DRAWINGS

The above and other objects and features of the present disclosure will become apparent by describing in detail embodiments thereof with reference to the accompanying drawings.
FIG. 1 is a block diagram of an electronic device according to some embodiments of the present disclosure.
FIG. 2 illustrates schematic views of an electronic device according to some embodiments.
FIG. 3 is a perspective view of an electronic device according to some embodiments of the present disclosure.
FIGS. 4 and 5 are views illustrating a folding state of the electronic device illustrated in FIG. 3.
FIG. 6 is a view schematically illustrating a cross section of a display device included in the electronic device illustrated in FIG. 2.
FIG. 7 is a view illustrating a cross section of a display panel illustrated in FIG. 6 by way of example.
FIG. 8 is a plan view of a display panel illustrated in FIG. 6.
FIG. 9 is a perspective view of an electronic device including a folding set according to some embodiments of the present disclosure.
FIG. 10 is an exploded perspective view of the electronic device illustrated in FIG. 9.
FIG. 11 is an exploded perspective view of a folding set illustrated in FIG. 10.
FIG. 12 is an exploded view illustrating any one hinge illustrated in FIG. 11, portions of first and second body parts, which are adjacent to the hinge, and portions of first and second wing plates, which are adjacent to the hinge.
FIG. 13 is an exploded perspective view of any one hinge illustrated in FIG. 11.
FIG. 14 is a view illustrating a coupled state of a bracket, a second rotator, and a second rotation link illustrated in FIGS. 12 and 13.
FIG. 15 is a side view of curved guide grooves of first and second rotators illustrated in FIGS. 12 and 13 and brackets, when viewed in a second direction.
FIG. 16 is a side view of the second rotator illustrated in FIGS. 12 and 13, when viewed in a second direction.
FIG. 17 is a side view of the first and second rotators and the first and second wing plates illustrated in FIGS. 12 and 13, when viewed in a second direction.
FIGS. 18A to 18C are views illustrating rotation states of first and second rotators and first and second rotation links according to a folding operation of a folding set.
FIGS. 19A to 19C are views illustrating unfolding and folding states of an electronic device.
FIG. 20 is a view illustrating movement coordinates of a roller rotation axis with respect to an x axis and a y axis illustrated in FIG. 19A.
FIGS. 21 and 22 are views illustrating shapes of guide grooves according to some embodiments of the present disclosure.
FIG. 23 is a view illustrating x-axis and y-axis coordinates corresponding to the roller rotation axis illustrated in FIGS. 21 and 22.
FIGS. 24 and 25 are views illustrating a configuration of a guide groove according to some embodiments of the present disclosure.

### DETAILED DESCRIPTION

In the specification, the expression that a first component (or area, layer, part, portion, etc.) is "on", "connected with", or "coupled with" a second component means that the first component is directly on, connected with, or coupled with the second component or means that a third component is interposed therebetween.

The same reference numerals refer to the same components. Furthermore, in drawings, the thickness, ratio, and dimension of components are exaggerated for effectiveness of description of technical contents. The term "and/or" includes one or more combinations in each of which associated elements are defined.

Although the terms "first", "second", etc. may be used to describe various components, the components should not be construed as being limited by the terms. The terms are used only for the purpose of distinguishing one component, part, area, layer, or portion from another component, part, area, layer, or portion. For example, without departing from the scope of the present disclosure, a first component, a first part, a first area, a first layer, or a first portion may be referred to as a second component, a second part, a second area, a second layer, or a second portion, and similarly, a second component, a second part, a second area, a second layer, or a second portion may be referred to as a first component, a first part, a first area, a first layer, or a first portion. Singular forms include plural forms unless interpreted otherwise in context.

Also, the terms "under", "below", "on", "above", and the like are used to describe the correlation of components illustrated in drawings. The terms are relative concepts, and are described with respect to directions indicated in the drawings.

It will be understood that the terms "include", "comprise", "have", and the like specify the presence of features, numbers, steps, operations, elements, or components, described in the specification, or a combination thereof, not precluding the presence or additional possibility of one or more other features, numbers, steps, operations, elements, or components or a combination thereof.

Unless otherwise defined, all terms (including technical terms and scientific terms) used in the specification have the same meaning as commonly understood by one skilled in the art to which the present disclosure belongs. Furthermore, the terms, such as the terms defined in dictionaries, which are generally used, should be construed to coincide with the context meanings of the related technologies, and are not construed as ideal or excessively formal meanings unless explicitly defined in the present disclosure.

Hereinafter, aspects of some embodiments of the present disclosure will be described in more detail with reference to accompanying drawings.

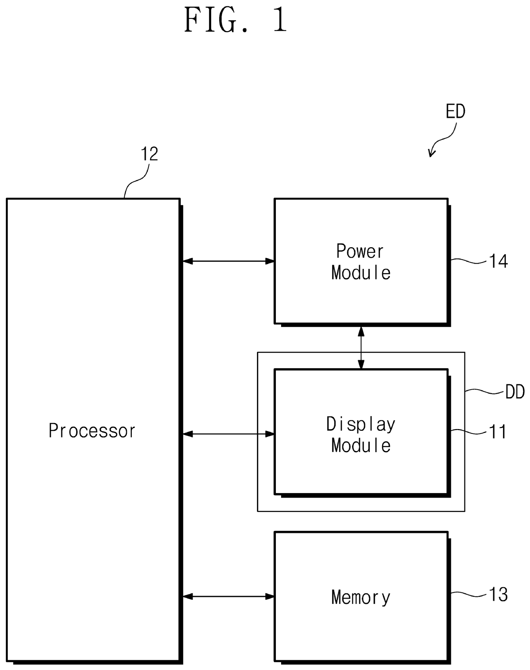

FIG. 1 is a block diagram of an electronic device according to some embodiments of the present disclosure.

Referring to FIG. 1, an electronic device ED according to some embodiments includes a display device DD, and may further include a module or device having other additional functions in addition to the display device DD. The electronic device ED according to some embodiments may include a display module 11, a processor 12, a memory 13, and a power module 14, and the display device DD may include a display module 11.

The processor 12 may include at least one of a central processing unit (CPU), an application processor (AP), a graphic processing unit (GPU), a communication processor (CP), an image signal processor (ISP), or a controller.

Data information that may be necessary for an operation of the processor 12 or the display module 11 may be stored in the memory 13. When the processor 12 executes an application stored in the memory 13, an image data signal and/or an input control signal may be transmitted to the display module 11, and the display module 11 may process the provided signal and output image information through a display screen.

The power module 14 may include a power supply module, such as a power adapter or a battery device, and a power conversion module that converts electric power supplied by the power supply module to generate electric power that is required for an operation of the electronic device ED.

At least one of the components of the electronic device ED described above may be included in the display device DD according to the above-described embodiments. Furthermore, some of the individual modules that are functionally included in one module may be included in the display device DD, and others may be provided separately from the display device DD. For example, the display device DD includes a display module 11, and the processor 12, the memory 13, and the power module 14 may be provided in the form of other devices in the electronic device ED rather than the display device DD.

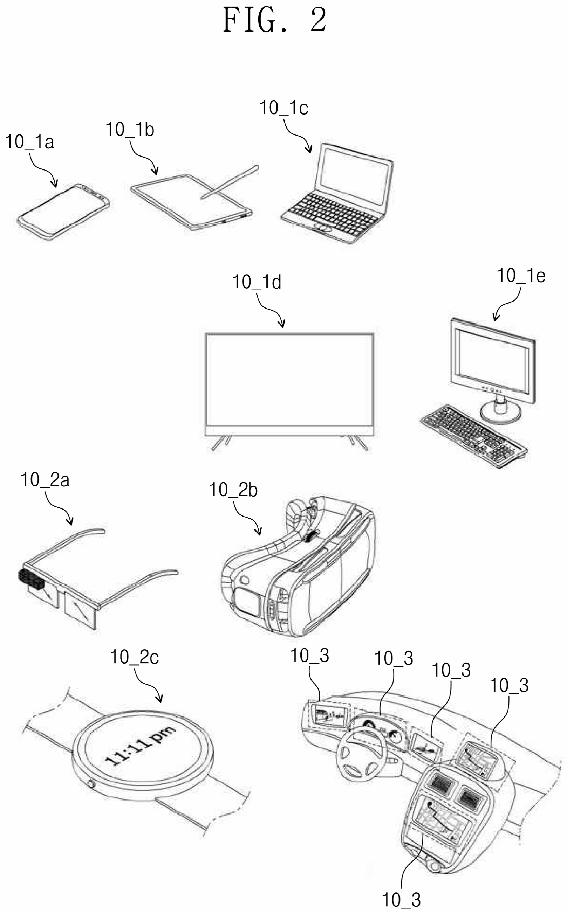

FIG. 2 illustrates schematic views of an electronic device according to various embodiments.

Referring to FIG. 2, the display device DD according to some embodiments of the present disclosure may be applied to various electronic devices. For example, various electronic devices, to which the display device DD according to some embodiments is applied, may include electronic devices for image display, such as a smartphone 10_1a, a tablet PC 10_1b, a laptop 10_1c, a TV 10_1d, and a desk monitor 10_1e.

Furthermore, various electronic devices, to which the display device DD according to some embodiments is applied, may include wearable electronic devices, such as smart glasses 10_2a, a head mounted display 10_2b, and a smart watch 10_2c. Furthermore, various electronic devices, to which the display device DD according to some embodiments is applied, may include electronic devices 10_3 for vehicles, such as an instrument panel for a vehicle, a center fascia, a center information display (CID) arranged on a dashboard, and a room mirror display.

According to some embodiments of the present disclosure, electronic devices, such as a smartphone 10_1a, a tablet PC 10_1b, and a laptop 10_1c may be foldable electronic devices.

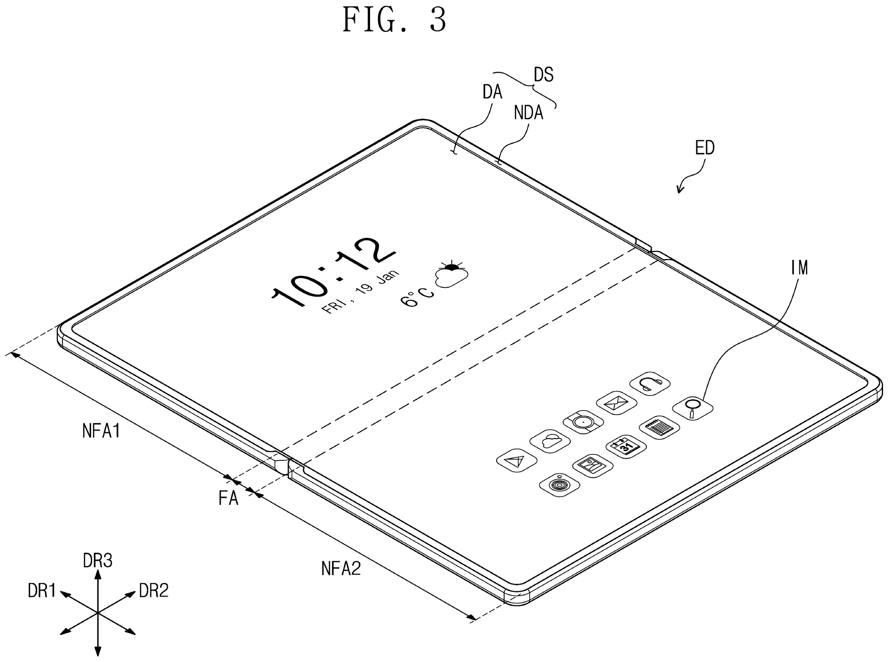

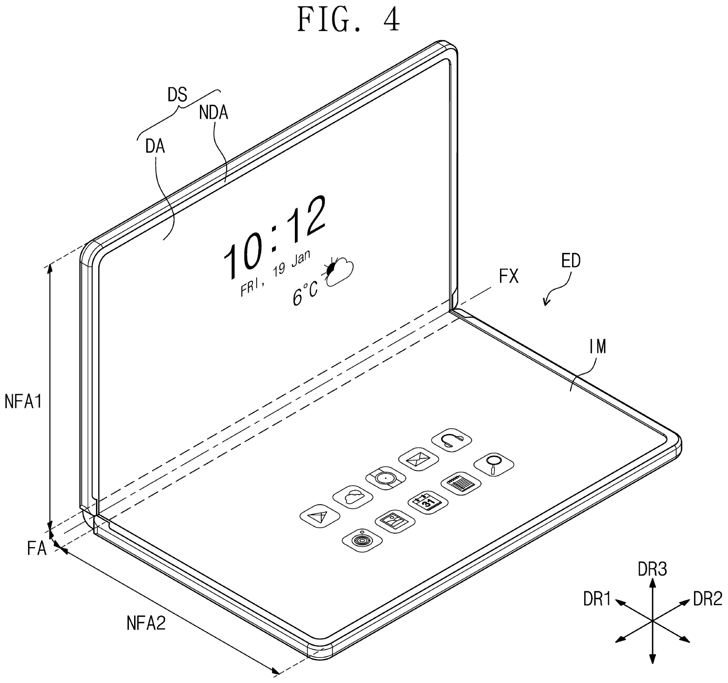

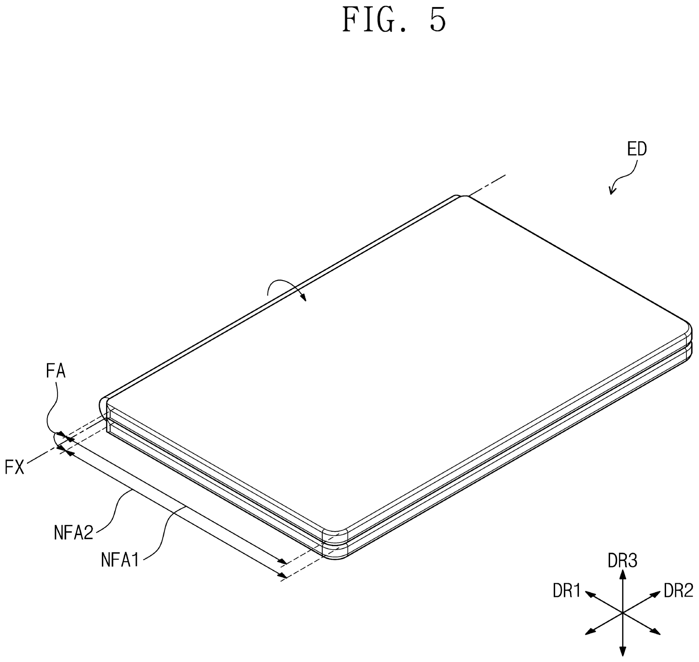

FIG. 3 is a perspective view of an electronic device according to some embodiments of the present disclosure. FIGS. 4 and 5 are views illustrating a folding state of the electronic device illustrated in FIG. 3.

By way of example, the electronic device ED illustrated in FIG. 3 may be a tablet PC or a laptop computer, and may be a foldable electronic device.

Referring to FIG. 3, the electronic device ED according to some embodiments of the present disclosure may have long sides that extend in parallel in a first direction DR1 and short sides that extend in parallel in a second direction DR2 that crosses the first direction DR1. Corners of the electronic device ED, which connect the long sides and the short sides of the electronic device ED, may have a curved shape. The corners of the electronic device ED having the curved shape may be defined as rounded corners. A shape of the electronic device ED may be defined as a round-cornered rectangular shape.

Hereinafter, a direction that is perpendicular (or substantially perpendicular) to a plane defined by the first direction DR1 and the second direction DR2 is defined as a third direction DR3. In the specification, the phrases "when viewed on a plane" or "in a plan view" may be defined as a state, in which it is viewed from the third direction DR3.

The electronic device ED may include a folding area FA and a plurality of non-folding areas NFA1 and NFA2. The non-folding areas NFA1 and NFA2 may include a first non-folding area NFA1 and a second non-folding area NFA2. The folding area FA may be located between the first non-folding area NFA1 and the second non-folding area NFA2. The first non-folding area NFA1, the folding area FA, and the second non-folding area NFA2 may be arranged in the first direction DR1.

By way of example, one folding area FA and two non-folding areas NFA1 and NFA2 are illustrated, but the numbers of the folding areas FA and the non-folding areas NFA1 and NFA2 are not limited thereto. For example, the electronic device ED may include more than two non-folding areas, and a plurality of folding areas that are arranged between the non-folding areas.

An upper surface of the electronic device ED may be defined as a display surface DS, and may have a plane that is defined by the first direction DR1 and the second direction DR2. Images IM generated by the electronic device ED may be provided to the user through a display surface DS.

The display surface DS may include a display area DA and a non-display area NDA around the display area DA. The display area DA may be an area where images are displayed, and the non-display area NDA may be an area where images are not displayed. The non-display area NDA may surround the display area DA and may define a border of the electronic device ED printed in a color (e.g., a set or predetermined color).

According to some embodiments, the electronic device ED may further include at least one sensor and at least one camera.

Referring to FIGS. 4 and 5, the electronic device ED may be a flexible display device. The electronic device ED may be a foldable electronic device ED that is folded or unfolded. For example, the folding area FA may be bent with respect to a folding axis FX that is parallel to the second direction DR2, so that the electronic device ED may be folded.

When the electronic device ED is folded, the first non-folding area NFA1 and the second non-folding area NFA2 may face each other. The electronic device ED may be in-folded so that the display surface DS is not exposed to the outside. However, embodiments of the present disclosure are not limited thereto. For example, the electronic device ED may be out-folded so that the display surface DS is exposed to the outside with respect to the folding axis FX.

Referring to FIG. 3, when the electronic device ED is in an unfolded state, the first non-folding area NFA1 and the second non-folding area NFA2 may be arranged in parallel in the first direction DR1. In this case, a folding angle between the first non-folding area NFA1 and the second non-folding area NFA2 may be 0 degree. That is, the first non-folding area NFA1 and the second non-folding area NFA2 may be arranged to form 0 degree with no angle difference.

Referring to FIG. 4, the electronic device ED may be folded such that the folding angle between the first non-folding area NFA1 and the second non-folding area NFA2 is 90 degrees. Like a laptop computer, the electronic device ED may be folded to 90 degrees, and an image may be provided to the user through a display surface DS of the folded electronic device. According to some embodiments, when the electronic device ED is a laptop computer, the electronic device ED may further include a keyboard that is an input device.

Referring to FIG. 5, the electronic device ED may be folded such that the folding angle between the first non-folding area NFA1 and the second non-folding area NFA2 is 180 degrees. For example, the first non-folding area NFA1 may be rotated by 180 degrees relative to the second non-folding area NFA2 so that the display surface DS of the first non-folding area NFA1 and the display surface DS of the second non-folding area NFA2 may face each other. Furthermore, the second non-folding area NFA2 may be rotated by 180 degrees relative to the first non-folding area NFA1 so that the display surface DS of the second non-folding area NFA2 and the display surface DS of the first non-folding area NFA1 may face each other.

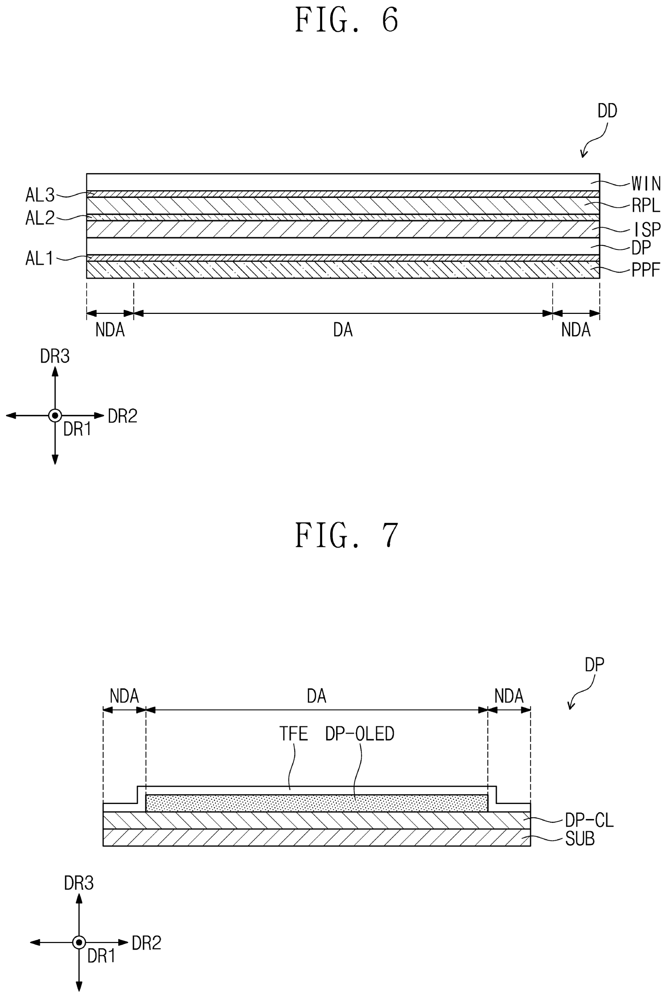

FIG. 6 is a view schematically illustrating a cross section of a display device included in the electronic device illustrated in FIG. 2.

FIG. 6 illustrates a cross-section of the display device DD, when viewed in the first direction DR1, by way of example.

Referring to FIG. 6, the display device DD may include a display area DA and a non-display area NDA around the display area DA. The display area DA and the non-display area NDA illustrated in FIG. 6 may correspond to the display area DA and the non-display area NDA of the electronic device ED illustrated in FIG. 1, respectively.

The display device DD may include a display panel DP, an input sensing part ISP, an anti-reflection layer RPL, a window WIN, a panel protection film PPF, and first, second, and third adhesive layers AL1, AL2, and AL3.

The display panel DP according to some embodiments of the present disclosure may be a light emitting display panel. For example, the display panel DP may be an organic light emitting display panel or an inorganic light emitting display panel. An emission layer of the organic light emitting display panel may include an organic light emitting material. An emission layer of the inorganic light emitting display panel may include a quantum dot and a quantum rod. Hereinafter, the display panel DP will be described as an organic light emitting display panel.

The input sensing part ISP may be located on the display panel DP. The input sensing part ISP may include a plurality of sensing parts for sensing an external input in a capacitive manner. The input sensing part ISP may be directly manufactured on the display panel DP when the display device DD is manufactured. However, the present disclosure is not limited thereto, and the input sensing part ISP may be manufactured as a separate panel from the display panel DP and attached to the display panel DP by an adhesive layer.

The anti-reflection layer RPL may be located on the input sensing part ISP. The anti-reflection layer RPL may be defined as an anti-reflection film of external light. The anti-reflection layer RPL may reduce a reflectance of external light input from the display device DD toward the display panel DP. External light may not be visually recognized by the user due to the anti-reflection layer RPL.

When the external light that has traveled toward the display panel DP is reflected from the display panel DP and provided again to an external user, such as a mirror, the user may visually recognize the external light. To prevent or reduce this phenomenon, for example, the anti-reflection layer RPL may include a plurality of color filters that display the same color as that of the pixels of the display panel DP.

The color filters may filter external light to the same color as that of the pixels. In this case, the external light may not be visually recognized by the user. However, the present disclosure is not limited to this, and the anti-reflection layer RPL may include a phase retarder and/or a polarizer to reduce the reflectance of the external light.

The window WIN may be located on the anti-reflection layer RPL. The window WIN may protect the display panel DP, the input sensing part ISP, and the anti-reflection layer RPL from external scratches and impacts.

The panel protection film PPF may be located under the display panel DP. The panel protection film PPF may protect a lower side of the display panel DP. The panel protection film PPF may include a flexible plastic material, such as polyethylene terephthalate (PET).

The first adhesive layer AL1 may be located between the display panel DP and the panel protection film PPF, and the display panel DP and the panel protection film PPF may be combined with each other by the first adhesive layer AL1. The second adhesive layer AL2 may be located between the input sensing part ISP and the anti-reflection layer RPL, and the input sensing part ISP and the anti-reflection layer RPL may be combined with each other by the second adhesive layer AL2. The third adhesive layer AL3 may be located between the window WIN and the anti-reflection layer RPL, and the window WIN and the anti-reflection layer RPL may be combined with each other by the third adhesive layer AL3.

The first to third adhesive layers AL1 to AL3 may include a transparent adhesive, such as a pressure sensitive adhesive (PSA) or an optically clear adhesive (OCA), but the type of adhesive is not limited thereto.

FIG. 7 is a view illustrating a cross section of a display panel illustrated in FIG. 6 by way of example.

By way of example, FIG. 7 illustrates a cross-section of the display panel DD, when viewed in the first direction DR1.

Referring to FIG. 7, the display panel DP may include a substrate SUB, a circuit element layer DP-CL located on the substrate SUB, a display element layer DP-OLED located on the circuit element layer DP-CL, and a thin film encapsulation layer TFE located on the display element layer DP-OLED.

The substrate SUB may include a display area DA and a non-display area NDA around the display area DA. The display area DA and the non-display area NDA illustrated in FIG. 7 may correspond to the display area DA and the non-display area NDA of the display device DD illustrated in FIG. 6, respectively.

The substrate SUB may include a flexible plastic material, such as glass or polyimide (PI). The display element layer DP-OLED may be located on the display area DA.

A plurality of pixels may be located on the circuit element layer DP-CL and the display element layer DP-OLED. Each of the pixels may include a transistor that is located on the circuit element layer DP-CL and a light emitting element that is located on the display element layer DP-OLED and is connected to the transistor.

A thin film encapsulation layer TFE may be located on the circuit element layer DP-CL to cover the display element layer DP-OLED. The thin film encapsulation layer TFE may protect pixels from moisture, oxygen, and external foreign substances.

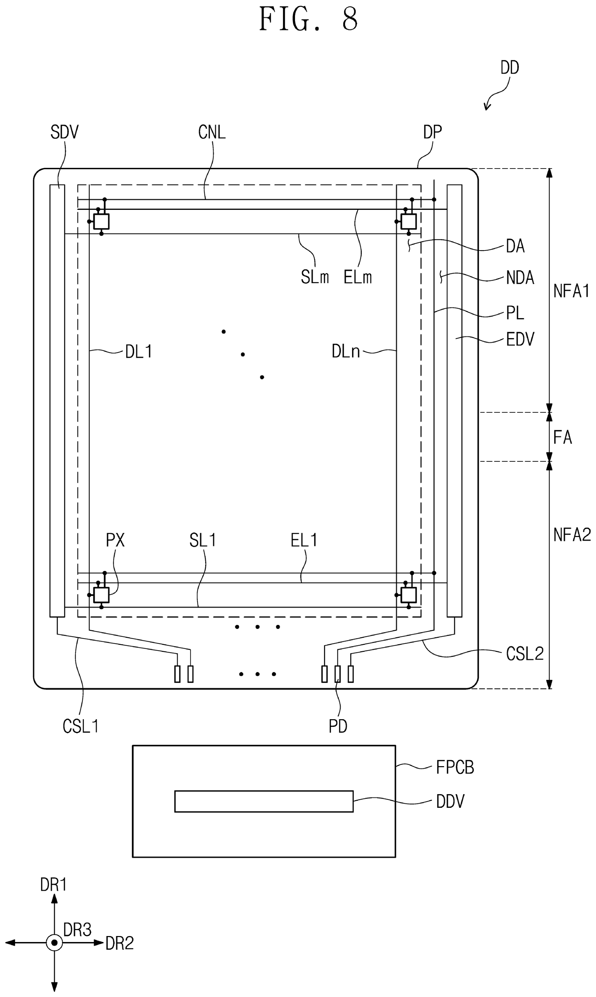

FIG. 8 is a plan view of a display panel illustrated in FIG. 6.

Referring to FIG. 8, the display device DD may include the display panel DP, a scan driver SDV, a data driver DDV, an emission driver EDV, a plurality of pads PD, and a flexible printed circuit board FPCB.

The display panel DP may have a round-cornered rectangular shape having long sides that extend in the first direction DR1 and short sides that extend in the second direction DR2. The display panel DP may include the display area DA, and the non-display area NDA that surrounds the display area DA. The display area DA and the non-display area NDA illustrated in FIG. 8 may correspond to the display area DA and the non-display area NDA of the display panel DP illustrated in FIG. 7, respectively.

The display panel DP may include a plurality of pixels PX, a plurality of scan lines SL1 to SLm, a plurality of data lines DL1 to DLn, a plurality of emission lines EL1 to ELm, first and second control lines CSL1 and CSL2, a power line PL, and a plurality of connection lines CNL. Each of 'm' and 'n' is a natural number.

The pixels PX may be positioned in the display area DA. The scan driver SDV and the emission driver EDV may be located in the non-display area NDA that is adjacent to opposite sides of the display panel DP, which are opposite to each other in the second direction.

The data driver DDV may be located on the flexible printed circuit board FPCB. The data driver DDV may be manufactured in the form of an integrated circuit chip and may be mounted on the flexible printed circuit board FPCB.

The pads PD may be located on the display panel DP. The pads PD may be adjacent to a lower end of the display panel DP. The pads PD may be arranged in the second direction DR2.

The scan lines SL1 to SLm may extend in the second direction DR2 so as to be connected to the pixels PX and the scan driver SDV. The emission lines EL1 to ELm may extend in the second direction DR2 so as to be connected to pixels PX and the emission driver EDV. The data lines DL1 to DLn may extend in the first direction DR1 so as to be connected to the pixels PX and the pads PD.

The flexible printed circuit board FPCB may be connected to the non-display area NDA that is adjacent to any one of the short sides of the display panel DP. For example, the flexible printed circuit board FPCB may be connected to the pads PD. Accordingly, when viewed on a plane, the flexible printed circuit board FPCB may be connected to the non-display area NDA that is adjacent to a lower end of the display panel DP.

The data driver DDV may be connected to the pads PD through the flexible printed circuit board FPCB. That is, the data driver DDV may be connected to the display panel DP through the flexible printed circuit board FPCB. However, the present disclosure is not limited thereto, and the data driver DDV may be directly located on the non-display area NDA of the display panel DP. The pads PD connected to the data lines DL1 to DLn may be connected to the data driver DDV through the flexible printed circuit board FPCB.

According to some embodiments, the flexible printed circuit board FPCB may include a plurality of wiring lines that are connected to the data driver DDV. The wiring lines may be connected to a plurality of chip pads located on the flexible printed circuit board FPCB. The chip pads may be connected to the pads PD so that the flexible printed circuit board FPCB and the data driver DDV may be connected to the display panel DP.

The power line PL may extend in the first direction DR1 and may be located in the non-display area NDA. The power line PL may be positioned between the display area DA and the emission driver EDV.

The connection lines CNL may extend in the second direction DR2 and be arranged in the first direction DR1 to be connected to the power line PL and the pixels PX. A first voltage may be applied to the pixels PX through the power line PL and the connection lines CNL that are connected to each other.

The second power line PL2 may be positioned in the non-display area NDA, and may extend along the long sides of the display panel DP and another short side of the display panel DP, at which the data driver DDV is not located. The second power line PL2 may be positioned outside the scan driver SDV and the emission driver EDV.

According to some embodiments, the second power line PL2 may extend toward the display area DA so as to be connected to the pixels PX. A second voltage having a level lower than a first voltage may be applied to the pixels PX through the second power line PL2.

A first control line CSL1 may be connected to the scan driver SDV and may extend toward a lower end of the display panel DP. A second control line CSL2 may be connected to the emission driver EDV and may extend toward a lower end of the display panel DP.

The data lines DL1 to DLn, the power line PL, the first control line CSL1, and the second control line CSL2 may be connected to pads PD.

According to some embodiments, the display device DD may include a timing controller that is manufactured from an integrated circuit chip and is mounted on a printed circuit board. The timing controller may be connected to the flexible printed circuit board FPCB through a printed circuit board. The timing controller may be connected to the data driver DDV, the scan driver SDV, and the emission driver EDV through the printed circuit board and the flexible printed circuit board FPCB. The timing controller may control operations of the scan driver SDV, the data driver DDV, and the emission driver EDV.

According to some embodiments, the display device DD may further include a voltage generator for generating first and second voltages. The voltage generator may be located on the printed circuit board.

The scan driver SDV may generate a plurality of scan signals, and the scan signals may be applied to the pixels PX through the scan lines SL1 to SLm. The data driver DDV may generate a plurality of data voltages, and the data voltages may be applied to the pixels PX through the data lines DL1 to DLn. The emission driver EDV may generate a plurality of emission signals, and the emission signals may be applied to the pixels PX through the emission lines EL1 to ELm.

The pixels PX may receive the data voltages in response to the scan signals. The pixels PX may display an image by emitting light of luminance corresponding to the data voltages in response to the emission signals.

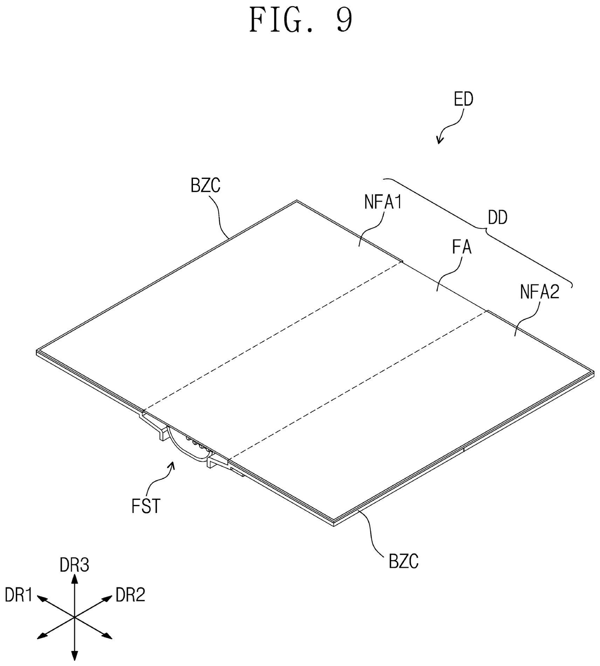

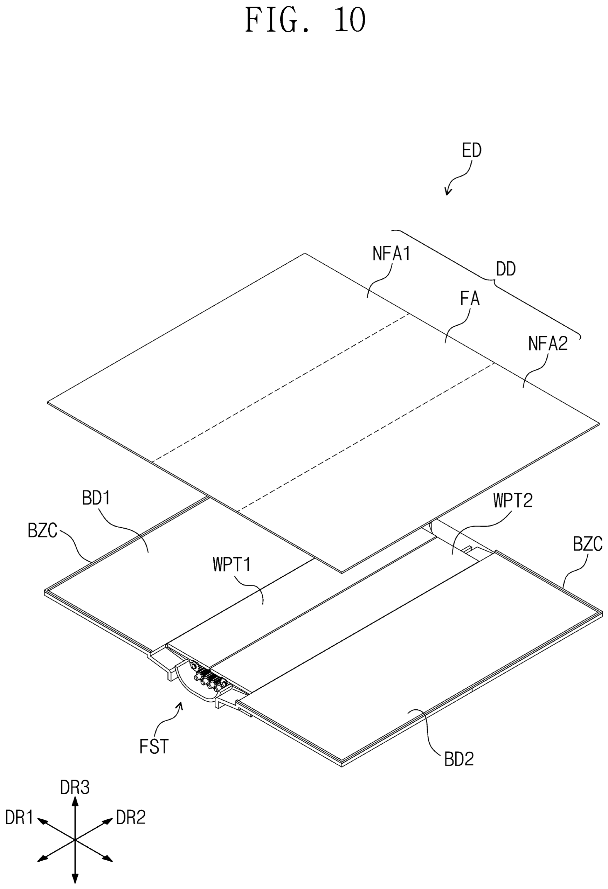

FIG. 9 is a perspective view of an electronic device including a folding set according to some embodiments of the present disclosure. FIG. 10 is an exploded perspective view of the electronic device illustrated in FIG. 9.

By way of example, in FIG. 10, the electronic device ED is divided into a folding set FST and the display device DD.

Referring to FIGS. 9 and 10, the electronic device ED may include a display device DD, a bezel cover BZC that is arranged around the display device DD, and a folding set FST that is located under the display device DD and the bezel cover BZC.

The bezel cover BZC may be arranged around the first and second non-folding areas NFA1 and NFA2 of the display device DD. The bezel cover BZC may be arranged to surround the first and second non-folding areas NFA1 and NFA2 of the display device DD. The bezel cover BZC may have black color, but the color of the bezel cover BZC is not limited thereto.

The folding set FST may support the display device DD and the bezel cover BZC. The display device DD and the bezel cover BZC may be attached to the folding set FST by an adhesive. The folding set FST may be defined as a folding mechanism for folding the display device DD.

The folding set FST may be folded around a biaxial folding axis that is parallel to the second direction DR2 and overlaps the folding area FA when viewed on a plane, so that the display device DD may be folded. Such a configuration will be described in detail below.

The folding set FST may include a first body BD1, a second body BD2, a first wing plate WPT1, and a second wing plate WPT2.

The first body BD1 and the second body BD2 may include a plane that is defined by the first and second directions DR1 and DR2. The first body BD1 and the second body BD2 may extend longer in the second direction DR2 than in the first direction DR1.

The first body BD1 and the second body BD2 may be arranged in the first direction DR1. The first body BD1 may be located under the first non-folding area NFA1, and may overlap the first non-folding area NFA1 when viewed on a plane. The second body BD2 may be located under the second non-folding area NFA2, and may overlap the second non-folding area NFA2 when viewed on a plane.

The bezel cover BZC may be separated in an area that overlaps the folding area FA. The bezel covers BZC separated from each other may be located on the first body BD1 and the second body BD2, respectively.

The first wing plate WPT1 and the second wing plate WPT2 may include a plane defined by the first and second directions DR1 and DR2. The first wing plate WPT1 and the second wing plate WPT2 may extend longer in the second direction DR2 than in the first direction DR1.

The first wing plate WPT1 and the second wing plate WPT2 may be arranged in the first direction DR1. The first wing plate WPT1 and the second wing plate WPT2 may be located under the folding area FA, and may overlap the folding area FA when viewed on a plane.

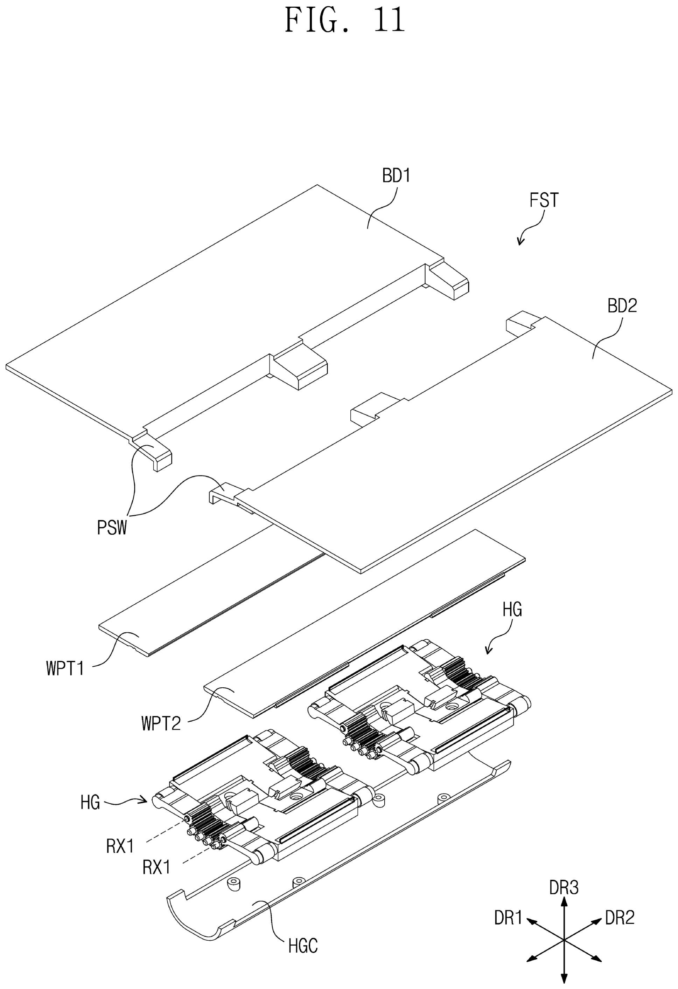

FIG. 11 is an exploded perspective view of a folding set illustrated in FIG. 10.

Referring to FIGS. 10 and 11, the folding set FST may include a plurality of hinges HG that are located under the first and second wing plates WPT1 and WPT2, and a hinge cover HGC that is located under the hinges HG.

The hinges HG may be arranged in the second direction DR2. By way of example, two hinges HG are illustrated, but the number of hinges HG is not limited thereto. When viewed on a plane, the hinges HG may overlap the first and second wing plates WPT1 and WPT2. The hinges HG may overlap the folding area FA when viewed on a plane. The hinges HG may define two first rotation axes RX1 that are spaced apart from each other in the first direction DR1 and extend in the second direction DR2. The first rotation axes RX1 may be defined as a biaxial rotation axis.

The first and second bodies BD1 and BD2 and the first and second wing plates WPT1 and WPT2 may be connected to the hinges HG. The first and second bodies BD1 and BD2 and the first and second wing plates WPT1 and WPT2 may be rotated around the first rotation axes RX1.

The first and second bodies BD1 and BD2 and the first and second wing plates WPT1 and WPT2 may be rotated so that the display device DD is folded. The first body BD1 and the first wing plate WPT1 that are adjacent to any one first rotation axis RX1 may be rotated around the any one first rotation axis RX1. The second body BD2 and the second wing plate WPT2 adjacent to another first rotation axis RX1 may be rotated around the other first rotation axis RX1.

The hinge cover HGC may extend in the second direction DR2. The hinge cover HGC may be located under the hinges HG to cover the hinges HG. A lower surface of the hinge cover HGC may have a downwardly convex curved surface, and an upper surface of the hinge cover HGC may have a downwardly concave curved surface.

The folding set FST may include a plurality of protruding side walls PSW that protrude from one side of the first body BD1 and one side of the second body BD2, which face each other in the first direction DR1. The protruding side walls PSW that protrude from the first body BD1 and the protruding side walls PSW that protrude from the second body BD2 may protrude toward each other. The protruding side walls PSW may be arranged in the second direction DR2. The hinges HG may be located between the protruding side walls PSW.

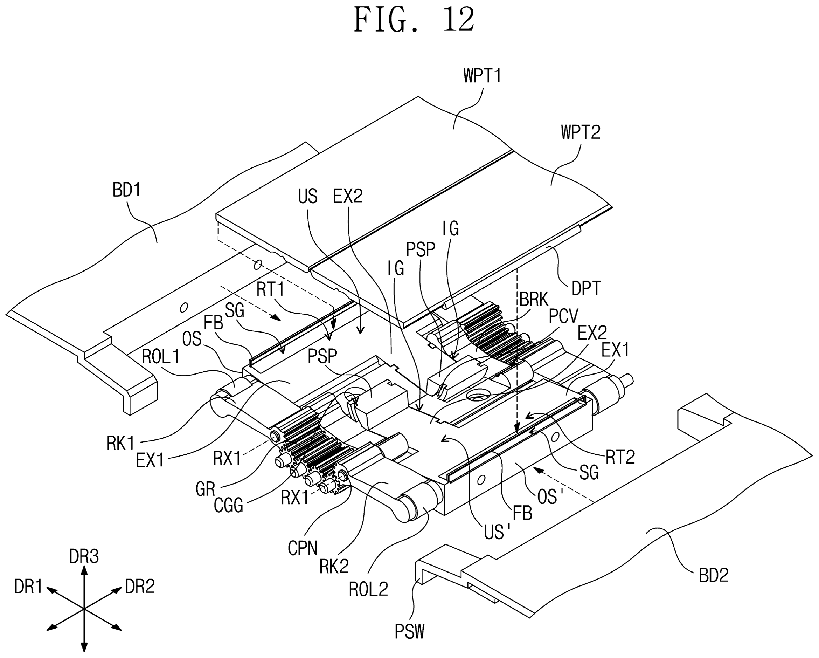

Because the hinges HG have the same (or substantially the same) configuration, hereinafter, an exploded perspective view of any one hinge HG will be illustrated in FIG. 12, and a detailed configuration of the hinge HG will be described.

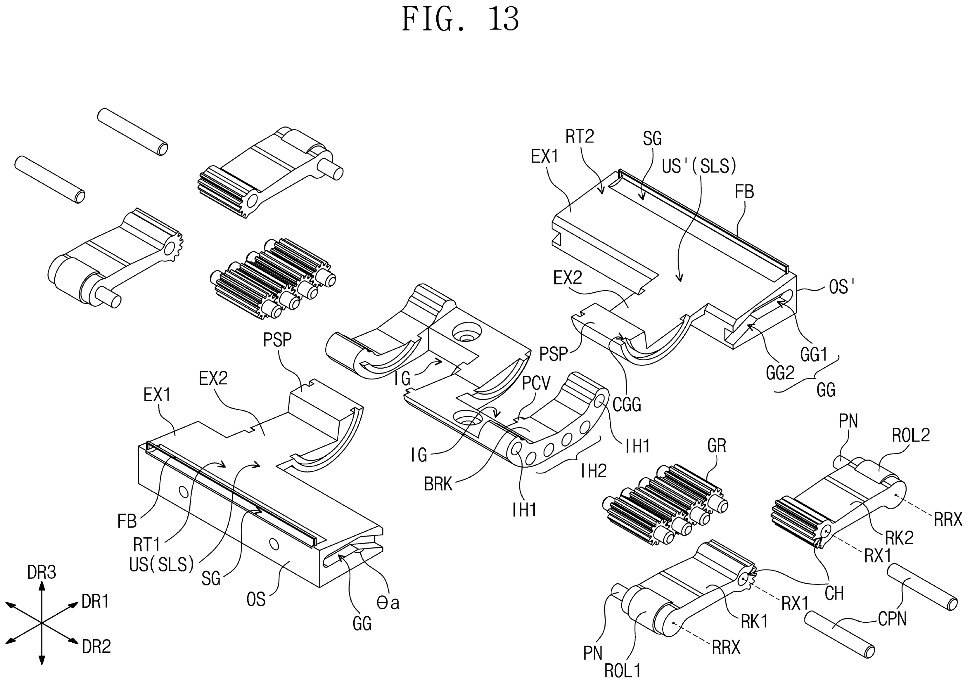

FIG. 12 is an exploded view illustrating any one hinge illustrated in FIG. 11, portions of first and second body parts, which are adjacent to the hinge, and portions of first and second wing plates, which are adjacent to the hinge. FIG. 13 is an exploded perspective view of any one hinge illustrated in FIG. 11.

By way of example, FIG. 12 illustrates a configuration of the folding set FST according to an unfolded state of the folding set FST and the display device DD.

Referring to FIGS. 12 and 13, opposite sides of the hinge HG, which are opposite to each other in the first direction DR1, may be located between the protruding side walls PSW. The hinge HG may include a bracket BRK, a first rotator RT1, a second rotator RT2, a plurality of first rotation links RK1, a plurality of second rotation links RK2, a plurality of protruding pins PN, a plurality of gears GR, and a plurality of coupling pins CPN.

The bracket BRK may extend longer in the second direction DR2 than in the first direction DR1. When viewed in the second direction DR2, the bracket BRK may have a shape that is bent downward. The bracket BRK may be located between the first body BD1 and the second body BD2.

A plurality of insertion grooves IG that are recessed toward an inside of the bracket BRK may be defined on opposite sides of the bracket BRK, which are opposite to each other in the first direction DR1. The insertion grooves IG may extend in the first direction DR1. The insertion grooves IG may be arranged to be misaligned.

The insertion grooves IG may be defined to correspond to the first rotator RT1 and the second rotator RT2. Accordingly, one insertion groove IG that is recessed to an inside of the bracket BRK may be defined on each of opposite sides of the bracket BRK. According to the two first and second rotators RT1 and RT2, two insertion grooves IG are defined in the bracket BRK, but the number of the insertion grooves IG may be variously set depending on the number of the first and second rotators RT1 and RT2.

A plurality of insertion holes IH1 and IH2 may be defined on opposite side surfaces of the bracket BRK, which are opposite to each other in the second direction DR2. In the observation position of the perspective view, the insertion holes IH1 and IH2 defined on one side surface of the bracket BRK are illustrated, but the insertion holes IH1 and IH2 may also be defined on an opposite side surface of the bracket BRK. The insertion holes IH1 and IH2 may be defined as being recessed toward the inside of the bracket BRK on opposite side surfaces of the bracket BRK, which are opposite to each other in the second direction DR2.

The insertion holes IH1 and IH2 may include a plurality of first insertion holes IH1 and a plurality of second insertion holes IH2. The first insertion holes IH1 may be spaced apart from each other in the first direction DR1. There are two first insertion holes IH1, and they may be adjacent to opposite sides of the bracket BRK, which are opposite to each other in the first direction DR1.

The second insertion holes IH2 may be located between the first insertion holes IH1. The second insertion holes IH2 may be arranged to be lower than the first insertion holes IH1. The second insertion holes IH2 may be arranged in the first direction DR1.

The first rotator RT1 may be located between the first body BD1 and the bracket BRK. The second rotator RT2 may be located between the second body BD2 and the bracket BRK. The first rotator RT1 and the second rotator RT2 may be coupled to the bracket BRK to be rotatable. Such a configuration will be described in detail below.

The first body BD1 may be connected to the first rotator RT1, and the second body BD2 may be connected to the second rotator RT2. For example, the first and second bodies BD1 and BD2 may be connected to the first and second rotators RT1 and RT2, respectively, by fastening means, such as screws.

One side of the first body BD1 and one side of the first rotator RT1 may face each other in the first direction DR1. One side of the second body BD2 and one side of the second rotator RT2 may face each other in the first direction DR1. One side of the first body BD1 may be connected to one side of the first rotator RT1, and one side of the second body BD2 may be connected to one side of the second rotator RT2.

Because the first and second bodies BD1 and BD2 are connected to the first and second rotators RT1 and RT2, the first and second bodies BD1 and BD2 may be moved together with the first and second rotators RT1 and RT2. For example, when the first and second rotators RT1 and RT2 are rotated with respect to the bracket BRK, the first and second bodies BD1 and BD2 may be rotated together with the first and second rotators RT1 and RT2.

Each of the first rotator RT1 and the second rotator RT2 may include a first extension EX1, a second extension EX2, and a protruding support PSP. The first extensions EX1 may extend in the second direction DR2.

The second extensions EX2 may extend from the portions of the first extensions EX1 toward the bracket BRK in the first direction DR1. The protruding supports PSP may protrude upward from ends of the second extensions EX2.

The second extension EX2 of the first rotator RT1 and the second extension EX2 of the second rotator RT2 may be arranged to be misaligned. The second extensions EX2 may be inserted into the insertion grooves IG, respectively.

When viewed in the second direction DR2, the second extensions EX2 may overlap the bracket BRK, and the first extensions EX1 may not overlap the bracket BRK. When viewed in the second direction DR2, the bracket BRK may be located between the first extensions EX1.

Guide grooves GG may be defined on opposite side surfaces of the first and second rotators RT1 and RT2, which are opposite to each other in the second direction DR2. Although the guide groove GG defined on one side of each of the first and second rotators RT1 and RT2 is illustrated at the observation position of the perspective view, the guide groove GG may also be defined on an opposite side of each of the first and second rotators RT1 and RT2. The guide grooves GG may be defined as being recessed toward an inside of each of the first and second rotators RT1 and RT2.

The guide grooves GG may be defined on opposite side surfaces of the first extensions EX1, which are opposite to each other in the second direction DR2, respectively. Accordingly, when viewed in the second direction DR2, the guide grooves GG may not overlap the bracket BRK. The bracket BRK may be located between the guide grooves GG. The guide grooves GG may be opened toward the bracket BRK.

Each of the guide grooves GG may include a first guide groove GG1, and a second guide groove GG2 extending from the first guide groove GG1 in a different direction. The first guide groove GG1 and the second guide groove GG2 may have a linear shape.

In the unfolding state, the first guide groove GG1 may extend in the first direction DR1, and the second guide groove GG2 may extend from the first guide groove GG1 toward a lower portion of the inside of the bracket BRK. The height of the second guide groove GG2 may gradually decrease as it becomes more distant from the first guide groove GG1, that is, as it becomes closer to the bracket BRK. The second guide groove GG2 may extend to form an angle θa that is greater than 90 degree and smaller than 180 degrees with respect to the first guide groove GG1.

The hinge HG may include a plurality of curved protrusions PCV that protrude from the inner surfaces of the brackets BRK, which face each other in the second direction DR2 in the insertion groove IG.

Curved guide grooves CGG may be defined on opposite side surfaces of the protruding supports PSP, which are opposite to each other in the second direction DR2, and opposite side surfaces of the second extensions EX2, which are opposite to each other in the second direction DR2. The curved guide grooves CGG may be continuously defined on opposite side surfaces of the protruding supports PSP and opposite side surfaces of the second extensions EX2. The curved protrusions PCV may be inserted into the curved guide grooves CGG, respectively.

Seating grooves SG may be defined on an upper side of one side surface OS of the first rotator RT1, which faces the first body BD1, and on an upper side of one side surface OS' of the second rotator RT2, which faces the second body BD2, respectively. The seating grooves SG may be defined at a portion of an upper surface US of the first rotator RT1, which is adjacent to one side surface OS of the first rotator RT1, and a portion of an upper surface US' of the second rotator RT2, which is adjacent to one side surface OS' of the second rotator RT2. The seating grooves SG may have a downwardly concave shape. The seating grooves SG may extend in the second direction DR2.

The hinge HG may include a plurality of fixing bars FB that are connected to the first extensions EX1 and are spaced upward apart from the first extensions EX1. The fixing bars FB may be adjacent to one of the side surfaces OS and OS' of the first extensions EX1, respectively. The fixing bars FB may extend in the second direction DR2. Opposite sides of the fixing bars FB, which are opposite to each other in the second direction DR2, may be connected to the first extensions EX1. The fixing bars FB may be located on the seating grooves SG, respectively.

A first wing plate WPT1 may be located on the bracket BRK and the first rotator RT1. A second wing plate WPT2 may be located on the bracket BRK and the second rotator RT2.

One side of the first wing plate WPT1 and one side of the second wing plate WPT2 may face each other. The hinge HG may include a plurality of dummy protrusions DPT that protrude from an opposite side of the first wing plate WPT1, which is opposite to one side of the first wing plate WPT1, and an opposite side of the second wing plate WPT2, which is opposite to one side of the second wing plate WPT2.

Although a dummy protrusion DPT that protrudes from the second wing plate WPT2 is illustrated at the observation position of the perspective view, the dummy protrusion DPT may protrude from the first wing plate WPT1. Lower surfaces of the dummy protrusions DPT may have a downwardly convex curved surface. The dummy protrusions DPT may extend in the second direction DR2.

A pair of first rotation links RK1 may be arranged in the second direction DR2, and a pair of second rotation links RK2 may be arranged in the second direction DR2. The bracket BRK and the first and second rotators RT1 and RT2 may be located between the first rotation links RK1 and the second rotation links RK2 in the second direction DR2.

Gears GR may be engaged with each other in the first direction DR1 and may be spaced apart from each other in the second direction DR2. Coupling pins CPN may be arranged in the first direction DR1 and may be spaced apart from each other in the second direction DR2. The bracket BRK and the first and second rotators RT1 and RT2 may be located between the gears GR and between the coupling pins CPN in the second direction DR2.

The first rotation links RK1 may have the same (or substantially the same) configuration, and the second rotation links RK2 may have the same (or substantially the same) configuration. The gears GR may have the same (or substantially the same) configuration, and the coupling pins CPN may have the same (or substantially the same) configuration.

Accordingly, hereinafter, the configurations of the pair of first rotation links RK1 and second rotation links RK2 that are adjacent to each other in the first direction DR1 and the configuration of the hinge HG that is coupled to the pair of first rotation links RK1 and second rotation links RK2 will be mainly described.

A first rotation link RK1 may face the first rotator RT1 and the bracket BRK in the second direction DR2. A second rotation link RK2 may face the second rotator RT2 and the bracket BRK in the second direction DR2. The first rotation link RK1 and the second rotation link RK2 may be coupled to the bracket BRK to be rotatable. Such a configuration will be described in detail below.

The first rotation link RK1 and the second rotation link RK2 may extend in the first direction DR1, and may be arranged in the first direction DR1. The guide grooves GG may be defined on surfaces of the first and second rotators RT1 and RT2, which face the first and second rotation links RK1 and RK2. Accordingly, the guide grooves GG may face the first and second rotation links RK1 and RK2 in the second direction DR2, respectively.

One side of the first rotation link RK1 and one side of the second rotation link RK2, which face each other in the first direction DR1, may have a gear shape. Coupling holes CH may be defined at a portion of the first rotation link RK1, which is adjacent to one side of the first rotation link RK1, and a portion of the second rotation link RK2, which is adjacent to one side of the second rotation link RK2, respectively. The coupling holes CH may be defined as passing through the portions of the first and second rotation links RK1 and RK2 in the second direction DR2. When viewed in the second direction DR2, the coupling holes CH may overlap the first insertion holes IH1.

The gears GR may be located between one side of the first rotation link RK1 and one side of the second rotation link RK2. The gears GR may extend in the second direction DR2, and may be arranged in the first direction DR1. The gears GR may be arranged to be engaged with each other in the first direction DR1. When viewed in the second direction DR2, the gears GR may overlap the second insertion holes IH2.

The coupling pins CPN may extend in the second direction DR2. When viewed in the second direction DR2, the coupling pins CPN may overlap the coupling holes CH.

The hinge HG may include a plurality of protruding pins PN that protrude from the first and second rotation links RK1 and RK2 toward the first and second rotators RT1 and RT2. The protruding pins PN may protrude from a portion of the first rotation link RK1, which is adjacent to an opposite side of the first rotation link RK1, which is opposite to one side of the first rotation link RK1 and a portion of the second rotation link RK2, which is adjacent to an opposite side of the second rotation link RK2, which is opposite to one side of the second rotation link RK2.

The hinge HG may include a first roller ROL1 that is coupled to an opposite side of the first rotation link RK1 to be rotatable, and a second roller ROL2 coupled to an opposite side of the second rotation link RK2 to be rotatable. Each of the first and second rollers ROL1 and ROL2 may be rotated around a roller rotation axis RRX that overlaps a central point of a circle of each of the first and second rollers ROL1 and ROL2 and extends in the second direction DR2.

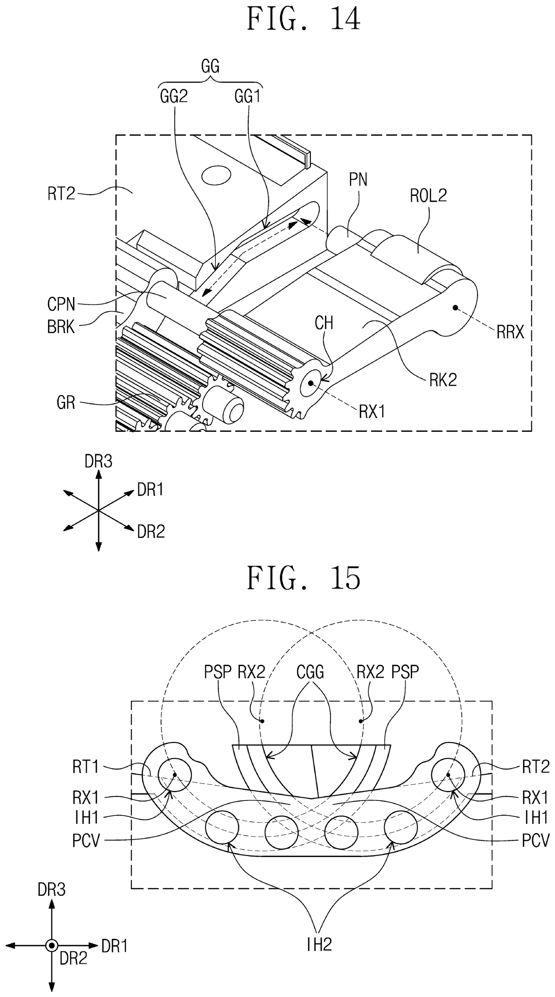

FIG. 14 is a view illustrating a coupled state of a bracket, a second rotator, and a second rotation link illustrated in FIGS. 12 and 13.

Referring to FIGS. 12, 13, and 14, the coupling pins CPN may be inserted into the coupling holes CH and the first insertion holes IH1 so that the first and second rotation links RK1 and RK2 may be coupled to the bracket BRK.

The first and second rotation links RK1 and RK2 may define two first rotation axes RX1. The first rotation axes RX1 that extend in the second direction DR2 may be defined at a portion that is adjacent to one side of the first rotation link RK1 and a portion that is adjacent to one side of the second rotation link RK2, respectively.

When viewed in the second direction DR2, the first rotation axes RX1 may overlap central points of the coupling pins CPN. Furthermore, when viewed in the second direction DR2, the first rotation axes RX1 may overlap the central points of the coupling holes CH and the central points of the first insertion holes IH1.

The first and second rotation links RK1 and RK2 may be rotated around the first rotation axes RX1. According to the structure, the first and second rotation links RK1 and RK2 may be coupled to the bracket BRK to be rotatable. A portion (for example, a portion, at which the corresponding first rotation axis RX1 is defined) of the first rotation link RK1, which is adjacent to one side of the first rotation link RK1 and a portion (for example, a portion, at which the corresponding first rotation axis RX1 is defined) of the second rotation link RK2, which is adjacent to one side of the second rotation link RK2 may be coupled to the bracket BRK to be rotatable.

The first and second rotation links RK1 and RK2 may be rotated around the first rotation axes RX1 in opposite directions. For example, when the first rotation link RK1 is rotated clockwise, the second rotation link RK2 may be rotated counterclockwise. Furthermore, when the first rotation link RK1 is rotated counterclockwise, the second rotation link RK2 may be rotated clockwise.

The protruding pins PN may be inserted into the guide grooves GG, respectively. When the first and second rotation links RK1 and RK2 rotate and the display device DD is folded and unfolded, the protruding pins PN may be moved along the guide grooves GG.

The gears GR may be inserted into the second insertion holes IH2 and coupled to the bracket BRK to be rotatable. For example, the gears GR may be rotated around rotation axes that extend in the second direction DR2. One of opposite sides of the gears GR, which are opposite to each other in the second direction DR2, may be inserted into the second insertion holes IH2.

The gears GR may be arranged to be engaged with one side of the first rotation link RK1 having a gear shape and one side of the second rotation link RK2 having a gear shape. When the first rotation link RK1 and the second rotation link RK2 are rotated around the first rotation axes RX1, the gears GR may also be rotated together with the first and second rotation links RK1 and RK2.

FIG. 15 is a side view of curved guide grooves of first and second rotators illustrated in FIGS. 12 and 13 and brackets, when viewed in a second direction.

By way of example, curved protrusions PCV that are located on an inner surface, on which the insertion groove IG of the bracket BRK is defined, and curved guide grooves CGG that are located in the insertion groove IG are illustrated in dotted lines.

Referring to FIGS. 12, 13, and 15, when viewed in the second direction DR2, the curved protrusions PCV may overlap the curved guide grooves CGG, respectively. The curved protrusion PCV and the curved guide groove CGG that overlap each other may have curved shapes corresponding to each other.

Second rotation axes RX2 may be defined on the first and second rotators RT1 and RT2, respectively. The second rotation axes RX2 may be defined as being spaced upward apart from the first and second rotators RT1 and RT2. The second rotation axes RX2 may be located on the second extensions EX2 of the first and second rotators RT1 and RT2, respectively, and may be defined as being higher than the protruding support PSP of the first and second rotators RT1 and RT2. The second rotation axes RX2 may extend in the second direction DR2.

A central point of a circle having the curved protrusion PCV and the curved guide groove CGG that overlap each other as arcs may be defined as the second rotation axis RX2. That is, the curved protrusion PCV and the curved guide groove CGG that overlap each other may be defined as an arc of a circle (indicated by a dotted line) having the second rotation axes RX2 located on each of the first and second rotators RT1 and RT2 as a central point.

The first and second rotators RT1 and RT2 may be rotated around the second rotation axes RX2. When the curved protrusions PCV are inserted into the curved guide grooves CGG and the first and second rotators RT1 and RT2 are rotated, the first and second rotators RT1 and RT2 may be moved along the curved protrusions PCV. According to the structure, the first and second rotators RT1 and RT2 may be coupled to the bracket BRK to be rotatable.

The first and second rotators RT1 and RT2 may be rotated around the second rotation axes RX2 in opposite directions. For example, when the first rotator RT1 is rotated clockwise, the second rotator RT2 may be rotated counterclockwise. Furthermore, when the first rotator RT1 is rotated counterclockwise, the second rotator RT2 may be rotated clockwise.

The second rotation axes RX2 may be spaced apart from the first rotation axes RX1. In the unfolding state, the second rotation axes RX2 may be located on an inside of the first rotation axes RX1. The second rotation axes RX2 may be arranged to be higher than the first rotation axes RX1.

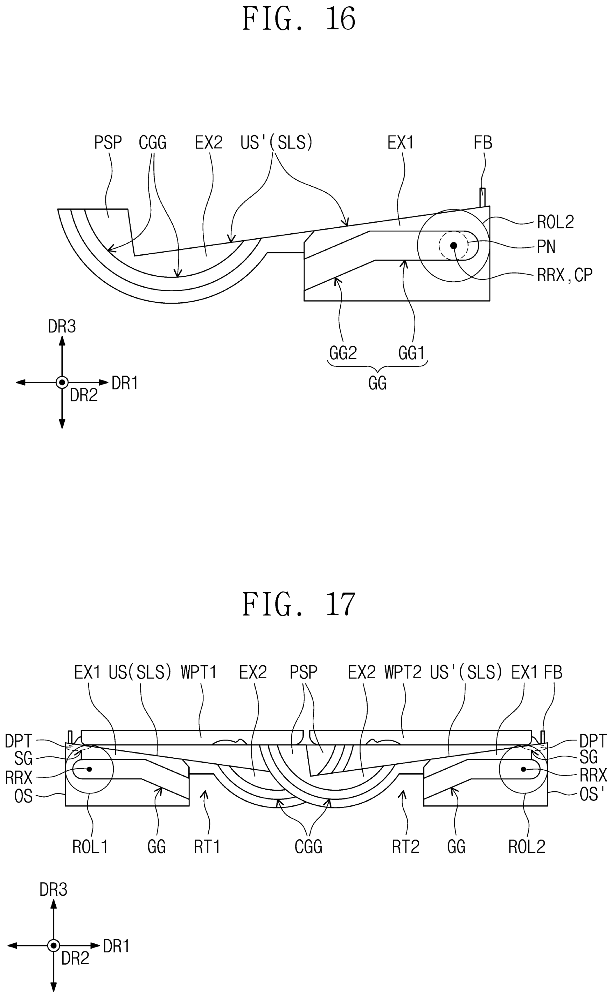

FIG. 16 is a side view of the second rotator illustrated in FIGS. 12 and 13, when viewed in a second direction.

By way of example, in FIG. 16, the second roller ROL2 and the protruding pin PN are illustrated together with the second rotator RT2, and the protruding pin PN is illustrated in a dotted line.

Referring to FIGS. 12, 13, and 16, when viewed in the second direction DR2, a central point CP of the protruding pin PN inserted into the guide groove GG of each of the first and second rotators RT1 and RT2 may overlap (or substantially overlap) the corresponding roller rotation axis RRX. That is, the central points CP of the protruding pins PN may overlap the central points of the first and second rollers ROL1 and ROL2, respectively.

Upper surfaces of the protruding supports PSP may have a plane that is defined by first and second directions DR1 and DR2.

The upper surface US of the first extension EX1 of the first rotator RT1 and the upper surface US of the second extension EX2 of the first rotator RT1 may have a continuously defined slanted surface SLS. Furthermore, the upper surface US' of the first extension EX1 of the second rotator RT2 and the upper surface US' of the second extension EX2 of the second rotator RT2 may have a continuously defined slanted surface SLS.

The heights of the slanted surfaces SLS may gradually decrease as they go toward the inside of the bracket BRK. That is, the height of the slanted surface SLS of the first rotator RT1 may gradually decrease as it goes toward the protruding support PSP of the first rotator RT1. Furthermore, the height of the slanted surface SLS of the second rotator RT2 may gradually decrease as it goes toward the protruding support PSP of the second rotator RT2.

FIG. 17 is a side view of the first and second rotators and the first and second wing plates illustrated in FIGS. 12 and 13, when viewed in a second direction.

By way of example, in FIG. 17, the first and second rollers ROL1 and ROL2 are illustrated together with the first and second rotators RT1 and RT2. In FIG. 17, portions of dummy protrusions DPT located on the seating grooves SG and the seating grooves SG are illustrated in dotted lines.

Referring to FIGS. 12, 13, and 17, dummy protrusions DPT may be located on the seating grooves SG, respectively. The portions of dummy protrusions DPT may be inserted between fixing bars FB and seating grooves SG.

The dummy protrusions DPT may be moved along the curved surfaces of the seating grooves SG. When the dummy protrusions DPT are moved along the curved surfaces of the seating grooves SG, the dummy protrusions DPT may be rotated around rotation axes that are parallel to the second direction DR2. According to this structure, the first wing plate WPT1 may be coupled to an upper side of one side surface OS of the first rotator RT1 to be rotatable, and the second wing plate WPT2 may be coupled to an upper side of one side surface OS' of the second rotator RT2 to be rotatable.

One side of the first wing plate WPT1 and one side of the second wing plate WPT2, which face each other in the first direction DR1, may be located on the protruding supports PSP. The first and second wing plates WPT1 and WPT2 may be located on the first and second rollers ROL1 and ROL2, respectively. In the unfolding state of the display device DD, uppermost ends of each of the first and second rollers ROL1 and ROL2 may be arranged to be higher than the portion of the slanted surface SLS on each of the roller rotation axes RRX.

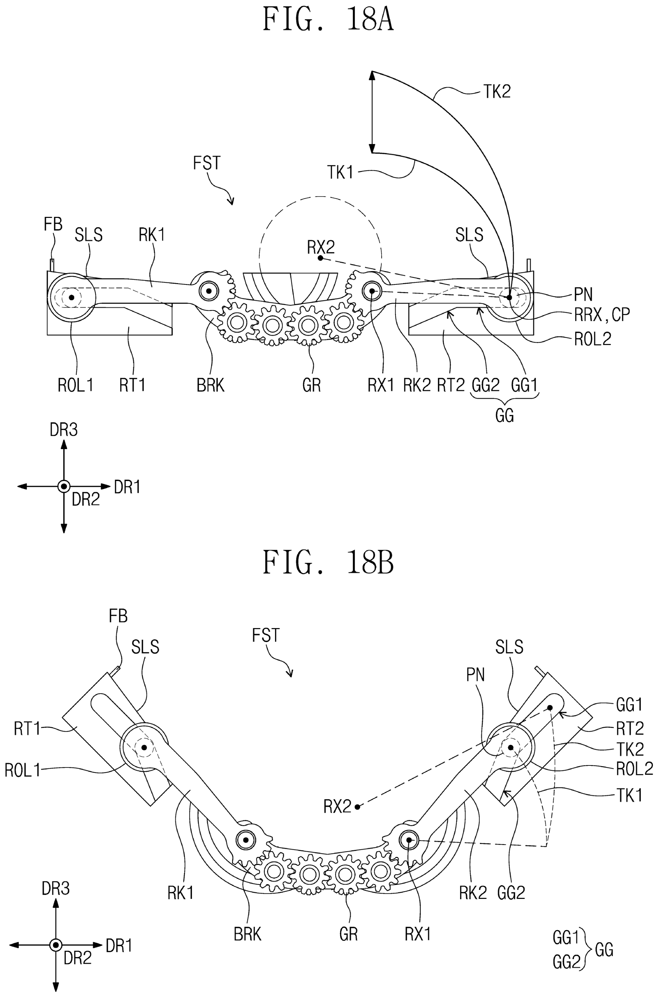

FIGS. 18A to 18C are views illustrating rotation states of first and second rotators and first and second rotation links according to a folding operation of a folding set.

By way of example, FIGS. 18A to 18C are side views of the brackets BRK, the first and second rotation links RK1 and RK2, the first and second rotators RT1 and RT2, and the gears GR coupled to each other, when viewed in the second direction DR2.

By way of example, in FIGS. 18A to 18C, the protruding pins PN and the guide grooves GG covered by the first and second rotation links RK1 and RK2 are illustrated in dotted lines.

Referring to FIGS. 18A to 18C, during the folding operation of the folding set FST, the first and second rotation links RK1 and RK2 may be rotated around the first rotation axes RX1, and the first and second rotators RT1 and RT2 may be rotated around the second rotation axes RX2, respectively.

Referring to FIG. 18A, when the first and second rotation links RK1 and RK2 are rotated around the first rotation axes RX1, a rotation track of each of the first and second rotation links RK1 and RK2 around the first rotation axes RX1 is defined as a first track TK1. In the unfolding state of the folding set FST, the first track TK1 may overlap each of the roller rotation axes RRX.

When the first and second rotators RT1 and RT2 are rotated around the second rotation axes RX2, a rotation track of each of the first and second rotators RT1 and RT2 with respect to the second rotation axes RX2 may be defined as a second track TK2. In the unfolding state of the folding set FST, the second track TK2 may overlap each of the roller rotation axes RRX.

The second track TK2 may be greater than the first track TK1. Each of the first and second rotation links RK1 and RK2 may be moved along the first track TK1, and each of the first and second rotators RT1 and RT2 may be moved along the second track TK2.

Referring to FIGS. 18A to 18C, when the first and second rotation links RK1 and RK2 and the first and second rotators RT1 and RT2 are rotated, the first and second rotation links RK1 and RK2 may be moved along the guide groove GG. Specifically, when the first and second rotation links RK1 and RK2 and the first and second rotators RT1 and RT2 are rotated, the protruding pins PN may be moved along the guide grooves GG.

In the unfolding state of the folding set FST, the protruding pins PN may be located in the first guide grooves GG1. When the folding set FST is folded, the protruding pins PN may be moved from the first guide grooves GG1 to the second guide grooves GG2 as a folding angle of the folding set FST increases. As the folding angle of the folding set FST increases, the protruding pins PN may be moved along the guide grooves GG to be adjacent to the bracket BRK.

When opposite sides (for example, portions, to which the first and second rollers ROL1 and ROL2 are coupled) of the first and second rotation links RK1 and RK2 are connected to and fixed to the first and second rotators RT1 and RT2, the rotation operations of the first and second rotation links RK1 and RK2 and the first and second rotators RT1 and RT2 may not be performed normally due to a difference between the first track TK1 and the second track TK2.

According to some embodiments of the present disclosure, the first track TK1 may be set to be smaller than the second track TK2, and the first and second rotation links RK1 and RK2 may be moved along the guide grooves GG. Accordingly, the rotation operations of the first and second rotation links RK1 and RK2 and the first and second rotators RT1 and RT2 may be normally performed.

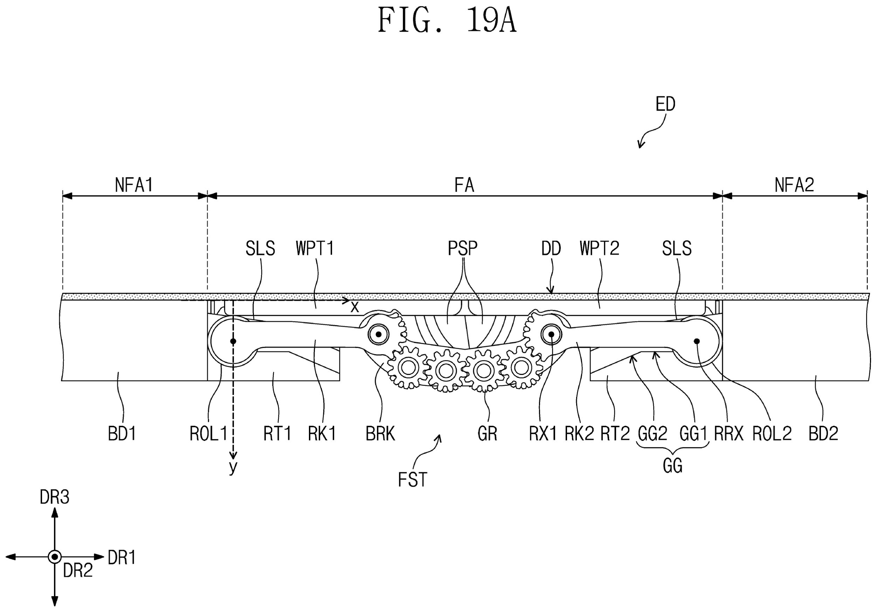

FIGS. 19A to 19C are views illustrating unfolding and folding states of an electronic device.

By way of example, FIGS. 19A to 19C are side views, in which the first and second wing plates WPT1 and WPT2, the first and second bodies BD1 and BD2, and the display device DD are coupled to the structures illustrated in FIGS. 18A to 18C. To illustrate the first and second rotation links RK1 and RK2, the protruding side walls PSW described above are omitted in FIGS. 19A to 19C.

The unfolding and folding states of FIGS. 19A to 19C may correspond to the unfolding and folding states of FIGS. 18A to 18C, respectively.

Referring to FIG. 19A, a display device DD may be located on the first and second wing plates WPT1 and WPT2 and the first and second bodies BD1 and BD2. The first and second non-folding areas NFA1 and NFA2 may be located on the first and second bodies BD1 and BD2, respectively. The folding area FA may be located on the first and second wing plates WPT1 and WPT2.

Referring to FIGS. 18A and 19A, when the electronic device ED or the display device DD is in an unfolding state, sides of the first and second wing plates WPT1 and WPT2, which face each other in the first direction DR1, may be located on the protruding supports PSP. Furthermore, opposite sides of the first and second wing plates WPT1 and WPT2 may be located on the first and second rollers ROL1 and ROL2.

As the first and second wing plates WPT1 and WPT2 are located on the first and second rollers ROL1 and ROL2 and the protruding supports PSP, the first and second wing plates WPT1 and WPT2 may not contact the slanted surfaces SLS. Accordingly, the first and second wing plates WPT1 and WPT2 may be spaced upward apart from the slanted surfaces SLS.

In the unfolding state, the arrangement state of the first non-folding area NFA1 and the second non-folding area NFA2 may be defined as 0 degree. Furthermore, the arrangement state of the first body BD1 and the second body BD2 may be defined as 0 degree. The first body BD1 and the second body BD2 are arranged in parallel (for example, in the first direction DR1), and this state may be defined in a state, in which the first body BD1 and the second body BD2 form an angle of 0 degree. That is, the folding angle between the first body BD1 and the second body BD2 may be 0 degree.

Referring to FIGS. 18A to 18C and 19A to 19C, the first and second bodies BD1 and BD2 may be rotated as the first and second rotation links RK1 and RK2 and the first and second rotators RT1 and RT2 are rotated. The display device DD may be folded and unfolded as the first and second bodies BD1 and BD2 are rotated. When the display device DD is folded and unfolded, the protruding pins PN may be moved along the guide grooves GG.

When the display device DD is changed from the unfolding state to the folded state, the protruding pins PN may be moved from the first guide grooves GG1 to the second guide grooves GG2. When the display device DD is changed from the folded state to the unfolding state, the protruding pins PN may be moved from the second guide grooves GG2 to the first guide grooves GG1.

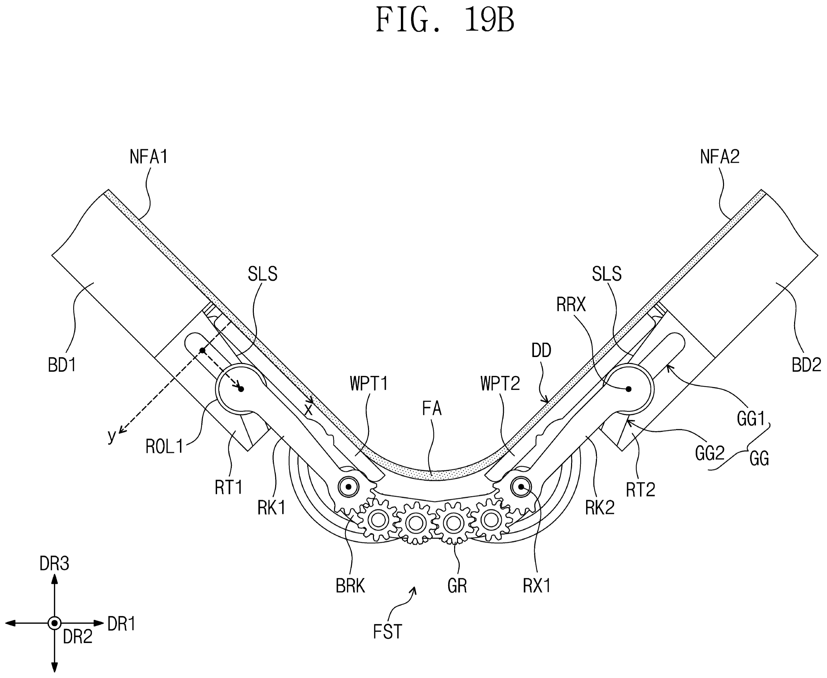

Referring to FIGS. 18A, 18B, 19A, and 19B, when the display device DD is folded, the first body BD1 and the second body BD2 may be rotated to form an angle of 90 degrees. The first body BD1 may be rotated clockwise at an angle of 45 degrees, and the second body BD2 may be moved counterclockwise at an angle of 45 degrees. Accordingly, a difference in the movement angles between the first body BD1 and the second body BD2 may be 90 degrees.

This state may be defined as a state in which the first body BD1 and the second body BD2 form an angle of 90 degrees. That is, the folding angle between the first body BD1 and the second body BD2 may be defined as 90 degrees. When a folding angle between the first body BD1 and the second body BD2 is 90 degrees, the first non-folding area NFA1 and the second non-folding area NFA2 may be arranged to form an angle of 90 degrees.

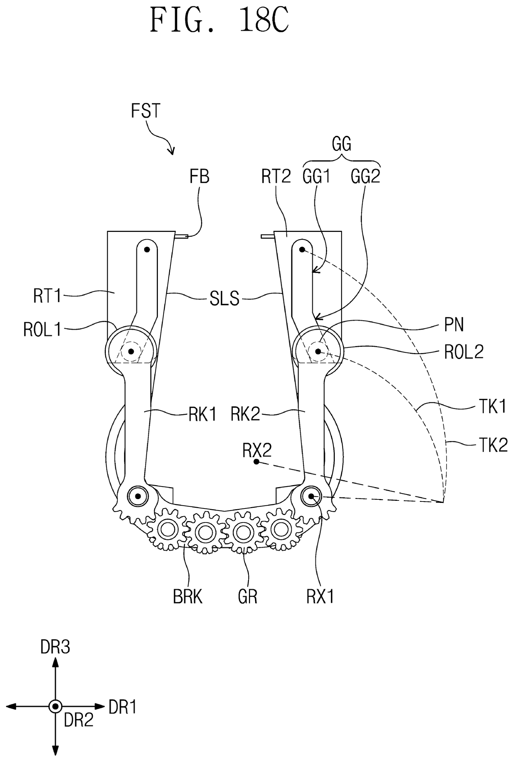

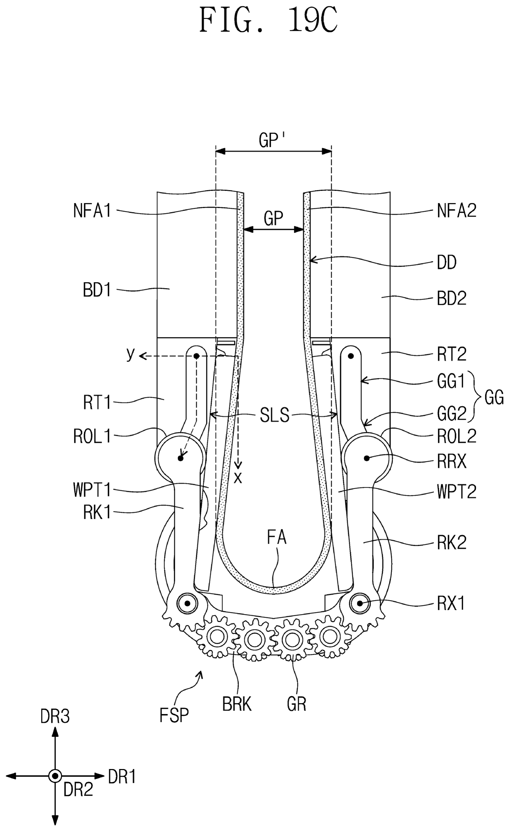

Referring to Figs. 18C and 19C, when the display device DD is folded, the first body BD1 and the second body BD2 may be rotated to form an angle of 180 degrees. The first body BD1 may be rotated clockwise at an angle of 90 degrees, and the second body BD2 may be moved counterclockwise at an angle of 90 degrees. A difference in the movement angles between the first body BD1 and the second body BD2 may be 180 degrees.

This state may be defined as a state in which the first body BD1 and the second body BD2 form an angle of 180 degrees. That is, the folding angle between the first body BD1 and the second body BD2 may be defined as 180 degrees. The first body BD1 and the second body BD2 that are arranged in parallel to each other in the unfolding state may face each other in the folding state illustrated in FIGS. 18C and 19C.

Although an operation of rotating the first body BD1 and the second body BD2 together is illustrated, the present disclosure is not limited thereto, and when the first body BD1 is fixed, the second body BD2 may be rotated by 180 degrees to face the first body BD1. Furthermore, when the second body BD2 is fixed, the first body BD1 may be rotated relatively by 180 degrees to face the second body BD2. That is, the folding state illustrated in FIGS. 18C and 19C may be defined as a state in which the first body BD1 and the second body BD2 form an angle of 180 degrees.

When a folding angle between the first body BD1 and the second body BD2 is 180 degrees, the first non-folding area NFA1 and the second non-folding area NFA2 may be arranged to form an angle of 180 degrees.

Referring to FIGS. 18A, 18B, 19A, and 19B, when the first body BD1 and the second body BD2 form an angle of 0 degree to 90 degrees, the protruding pins PN may be located on the first guide grooves GG1, and may be moved along the first guide grooves GG1. The first and second rollers ROL1 and ROL2 may be moved in an extension direction of the first guide groove GG1.

The first and second wing plates WPT1 and WPT2 may be located on the first and second rollers ROL1 and ROL2. Because the first and second rollers ROL1 and ROL2 are moved in the extension direction of the first guide groove GG1, the first wing plate WPT1 may be arranged parallel to the extension direction of the first guide groove GG1 located under the first wing plate WPT1. Furthermore, the second wing plate WPT2 may be arranged parallel to the extension direction of the first guide groove GG1 located under the second wing plate WPT2.

In this case, the first and second wing plates WPT1 and WPT2 may be spaced apart from the slanted surfaces SLS by the first and second rollers ROL1 and ROL2. Furthermore, an upper surface of the first wing plate WPT1 may be arranged in parallel to an upper surface of the first body BD1, and an upper surface of the second wing plate WPT2 may be arranged in parallel to an upper surface of the second body BD2.

Referring to FIGS. 18C and 19C, when the first body BD1 and the second body BD2 form an angle of more than 90 degrees and less than or equal to 180 degrees, the protruding pins PN may be located on the second guide grooves GG2 to be moved along the second guide grooves GG2. Because the second guide grooves GG2 extend from the first guide grooves GG1 toward a lower portion of the inside of the bracket BRK, the protruding pins PN may also be moved toward a lower portion of the inside of the bracket BRK. Furthermore, the first and second rollers ROL1 and ROL2 may also be moved toward a lower portion of the inside of the bracket BRK.

When the folding area FA is folded, the folding area FA may push out the first and second wing plates WPT1 and WPT2 toward the slanted surfaces SLS due to the elasticity of the folding area FA. Because the first and second rollers ROL1 and ROL2 are moved toward a lower portion of the inside of the bracket BRK, and the folding area FA pushes out the first and second wing plates WPT1 and WPT2 toward the slanted surfaces SLS, the first and second wing plates WPT1 and WPT2 may contact the slanted surfaces SLS. According to this structure, the display device DD may be folded in a dumbbell shape.

Referring to FIGS. 18B and 19B, when the first and second non-folding areas NFA1 and NFA2 form an angle of 90 degrees, the folding area FA may have a shape corresponding to a "U"-shaped curved surface. When the first and second non-folding areas NFA1 and NFA2 form an angle of 90 degrees and the folding area FA has a dumbbell shape, an image may be distorted and then provided to the user. However, according to some embodiments of the present disclosure, when the first and second non-folding areas NFA1 and NFA2 form an angle of 90 degrees, the folding area FA has a shape corresponding to the "U"-shaped curved surface, so that distortion of an image may be reduced.

Referring to FIGS. 18C and 19C, when the first and second non-folding areas NFA1 and NFA2 form an angle of 180 degrees, the folding area FA may have a shape corresponding to a dumbbell shape. In the folding state, an image may not be provided to the user. When the folding area FA is folded in a dumbbell shape, a gap GP between the first and second non-folding areas NFA1 and NFA2 that face each other may be set to a minimum. As a result, a thickness of the electronic device ED may be reduced.

When the folding area FA is folded in a "U" shape like a dotted line, the gap GP' between the first and second non-folding areas NFA1 and NFA2 becomes larger than the gap GP, so that the thickness of the electronic device ED may be increased.

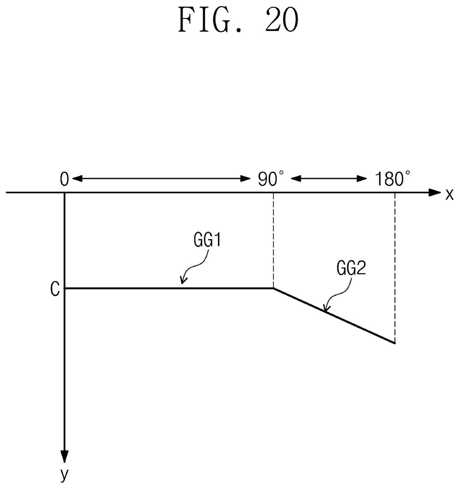

FIG. 20 is a view illustrating movement coordinates of a roller rotation axis with respect to an x axis and a y axis illustrated in FIG. 19A.

Referring to FIGS. 19A and 20, in the unfolding state, the "x" axis may be defined as a line that extends in parallel to an upper surface of the first body BD1 or an upper surface of the first wing plate WPT1. The "y" axis may be defined as a line that is perpendicular to the "x" axis and extends to overlap the roller rotation axis RRX. The "x" axis and the "y" axis may be fixed at positions that is defined in the folding set FST. The "x" axis and the "y" axis may define position coordinates of the roller rotation axis RRX.

Referring to FIGS. 19A to 19C and 10, when "x" has an angle value of 0 to 90 degrees, y=c may be defined. "c" is a constant value, and may be a y-axis value of the roller rotation axis RRX when the roller rotation axis RRX is moved along the first guide groove GG1. When the roller rotation axis RRX is moved along the first guide groove GG1, it is moved parallel to upper surfaces of the first body BD1 and the first wing plate WTP1, and thus, a y-axis value of the roller rotation axis RRX may have a constant "c" value.

When "x" has an angle value of more than 90 degrees and not more than 180 degrees, it may be defined as y=c+g(x). When the roller rotation axis RRX is moved along the second guide groove GG2, the y-axis value of the roller rotation axis RRX may be changed by the second guide groove GG2 that is defined as being inclined with respect to the first guide groove GG1. As the x-axis value increases, the y-axis value may decrease to a negative value. That is, "g" may have a negative value as an inclination. Accordingly, the movement position of the roller rotation axis RRX may be defined by a linear equation.

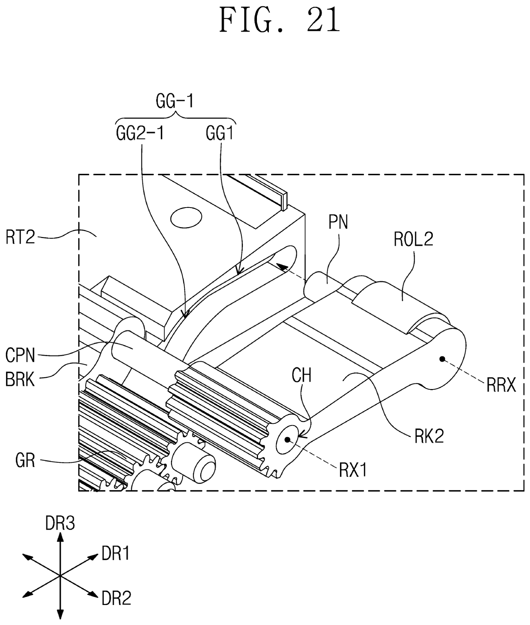

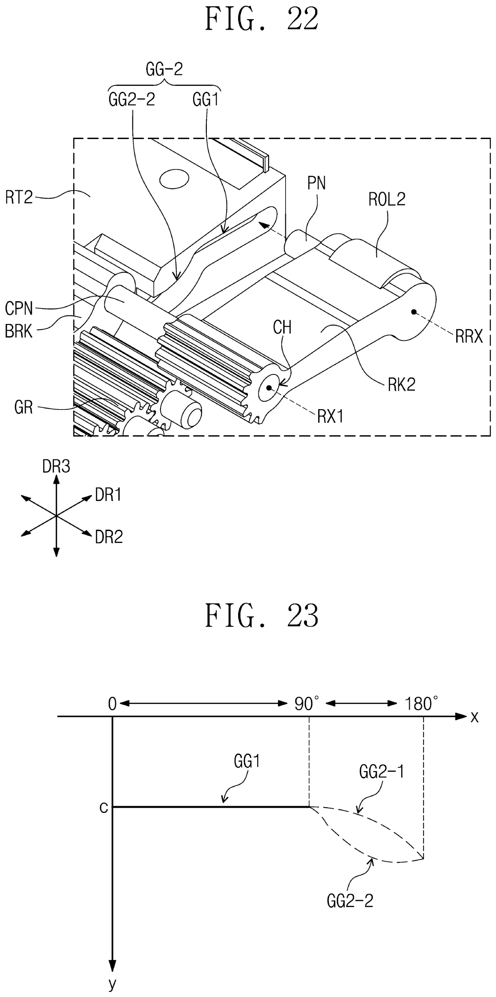

FIGS. 21 and 22 are views illustrating shapes of guide grooves according to some embodiments of the present disclosure. FIG. 23 is a view illustrating x-axis and y-axis coordinates corresponding to the roller rotation axis illustrated in FIGS. 21 and 22.

By way of example, FIGS. 21 and 22 are perspective views corresponding to FIG. 14, and FIG. 23 is a graph corresponding to FIG. 20. Hereinafter, configurations of the guide grooves GG-1 and GG-2 illustrated in FIGS. 21 and 22 will be described, focusing on a configuration that is different from that of the above-described guide groove GG.

Referring to FIGS. 21 and 23, the guide groove GG-1 may include a first guide groove GG1, and a second guide groove GG2-1 that extends from the first guide groove GG1 toward a lower portion of the inside of the bracket BRK. The second guide groove GG2-1 may have an upwardly convex curved shape. Accordingly, the roller rotation axis RRX may be moved to form a convex curved track in the second guide groove GG2-1.

Referring to FIGS. 22 and 23, the guide groove GG-2 may include a first guide groove GG1, and a second guide groove GG2-2 that extends from the first guide groove GG1 toward a lower portion of the inside of the bracket BRK. The second guide groove GG2-2 may have a downwardly convex curved shape. Accordingly, the roller rotation axis RRX may be moved to form a convex curved track in the second guide groove GG2-2.

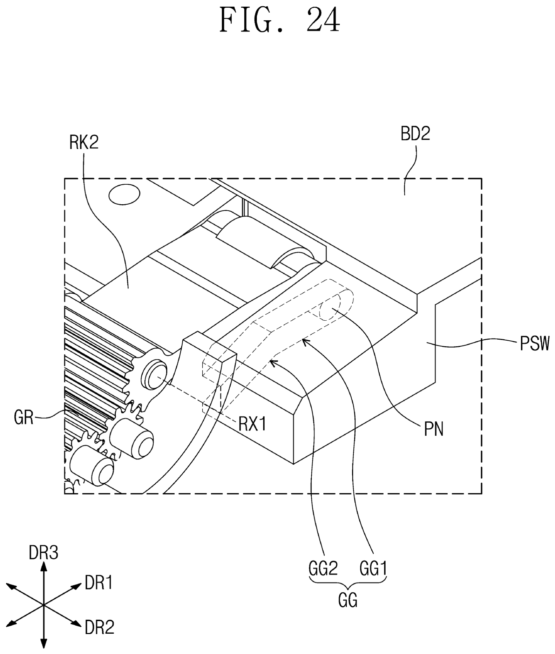

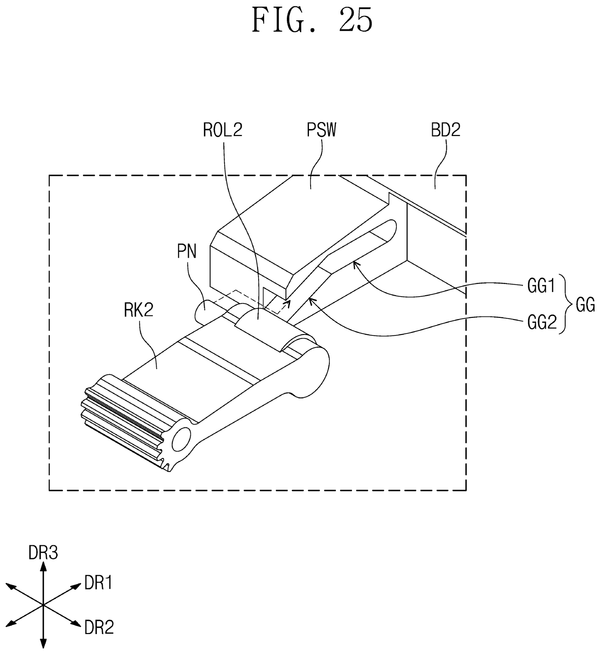

FIGS. 24 and 25 are views illustrating a configuration of a guide groove according to some embodiments of the present disclosure.

By way of example, any one protruding side wall PSW located at an outermost side in the second direction DR2, and a portion of the hinge HG, which is adjacent to the protruding side walls PSW are illustrated in FIG. 24. In FIG. 24, a guide groove GG defined inside a protruding side wall PSW and a protruding pin PN located on a guide groove GG are illustrated in dotted lines. By way of example, FIG. 25 illustrates a protruding side wall PSW, and a second rotation link RK2 coupled to the protruding side wall PSW, and other configurations are omitted.

Referring to FIGS. 24 and 25, the protruding pin PN may protrude from the second rotation link RK2 toward the protruding side wall PSW that faces the second rotation link RK2. The guide groove GG may be defined on one surface of the protruding side wall PSW, which faces the second rotation link RK2. The guide groove GG may include a first guide groove GG1 and a second guide groove GG2. A shape of the guide groove GG may be the same (or substantially the same) as that of the guide groove GG illustrated in FIG. 13.

The protruding pin PN may be inserted into the guide groove GG. According to some embodiments, the protruding pin PN may protrude from the first rotation link RK1 toward the protruding side wall PSW that faces the first rotation link RK1, and the guide groove GG may be defined on one surface of the protruding side wall PSW, which faces the first rotation link RK1. When the display device DD is folded and unfolded, the protruding pin PN may be moved along the guide groove GG.

According to some embodiments of the present disclosure, when the first and second non-folding areas of the display device form an angle of 90 degrees, the folding area may have a shape corresponding to the curved surface of the "U" shape, and when the first and second non-folding areas form an angle of 180 degrees, the folding area may have a shape corresponding to the dumbbell shape. Accordingly, the shape of the folding area may variously vary depending on the folding angle of the first and second non-folding areas.

When the first and second non-folding areas form an angle of 90 degrees, distortion of the image displayed on the folding area may be reduced because the folding area does not have a shape corresponding to the dumbbell shape but has a shape corresponding to the curved surface of the "U" shape.

When the first and second non-folding areas form an angle of 180 degrees, the folding area has a shape corresponding to the dumbbell shape, and thus, a gap between the first and second non-folding areas that face each other may be set to a minimum. As a result, the thickness of the electronic device may be reduced.

Although aspects of some embodiments of the present disclosure have been described for illustrative purposes, those skilled in the art will appreciate that various modifications, and substitutions are possible, without departing from the scope of embodiments according to the present disclosure as defined in the accompanying claims, and their equivalents.

Accordingly, the technical scope of embodiments according to the present disclosure should not be limited to the contents described in the detailed description of the specification but should be defined by the appended claims, and their equivalents.

## Claims

1. An electronic device (ED) comprising:
a display device (DD);
a first body (BD1) and a second body (BD2) arranged in a first direction (DR1) under the display device (DD);
a bracket (BRK) between the first body (BD1) and the second body (BD2);
a first rotator (RT1) and a second rotator (RT2) between the first body (BD1) and the bracket (BRK) and between the second body (BD2) and the bracket (BRK), respectively, and coupled to the bracket (BRK) to be rotatable;
a first rotation link (RK1) and a second rotation link (RK2) facing the first rotator (RT1) and the second rotator (RT2), respectively, in a second direction (DR2) crossing the first direction (DR1), and coupled to the bracket (BRK) to be rotatable; and
a plurality of protruding pins (PN) protruding from the first rotation link (RK1) and the second rotation link (RK2) toward the first rotator (RT1) and the second rotator (RT2), respectively, and in guide grooves (GG) defined on surfaces of the first rotator (RT1) and the second rotator (RT2) facing the first rotation link (RK1) and the second rotation link (RK2),
wherein each of the guide grooves (GG) includes a first guide groove (GG1), and a second guide groove (GG2) extending from the first guide groove (GG1) in another direction.

2. The electronic device (ED) of claim 1, wherein in an unfolding state of the display device (DD), the first guide groove (GG1) extends in the first direction (DR1), and the second guide groove (GG2) extends from the first guide groove (GG1) toward a lower side of an inside of the bracket (BRK).

3. The electronic device (ED) of claim 2, wherein the second guide groove (GG2) extends to form an angle (θa) being greater than 90 degrees and smaller than 180 degrees with respect to the first guide groove (GG1).

4. The electronic device (ED) of claim 3, wherein
a height of the second guide groove (GG2) becomes gradually smaller as it becomes more distant from the first guide groove (GG1).

5. The electronic device (ED) of claim 4, wherein the second guide groove (GG2) has a linear shape.

6. The electronic device (ED) of claim 4, wherein the second guide groove (GG2-1, GG2-2) has a curved shape.

7. The electronic device (ED) of any one of claims 1 to 6, wherein the first body (BD1) and the second body (BD2) are connected to the first rotator (RT1) and the second rotator (RT2), respectively,
wherein the display device (DD) is configured to be folded and unfolded based on the first body (BD1) and the second body (BD2) being rotated as the first rotation link (RK1) and the second rotation link (RK2), and the first rotator (RT1) and the second rotator (RT2) are configured to be rotated, and
wherein the protruding pins (PN) are configured to be moved along the guide grooves (GG) as the display device (DD) is folded and unfolded.

8. The electronic device (ED) of claim 7, wherein each of the protruding pins (PN) is configured to be moved from the first guide groove (GG1) to the second guide groove (GG2) as the display device (DD) is changed from an unfolding state to a folding state, optionally wherein each of the protruding pins (PN) is configured to be in the first guide groove (GG1) as the first body (BD1) and the second body (BD2) form an angle of 0 degree to 90 degrees, and
wherein each of the protruding pins (PN) is configured to be in the second guide groove (GG2) as the first body (BD1) and the second body (BD2) form an angle of more than 90 degrees and less than or equal to 180 degrees.

9. The electronic device (ED) of any one of claims 1 to 8, wherein each of the first rotation link (RK1) and the second rotation link (RK2) is configured to be rotated around a first rotation axis (RX1) extending in the second direction (DR2), and
wherein each of the first rotator (RT1) and the second rotator (RT2) is configured to be rotated around a second rotation axis (RX2) spaced apart from the first rotation axis (RX1) and extending in the second direction (DR2), optionally wherein in an unfolding state of the display device (DD), the second rotation axis (RX2) is on an inside of the first rotation axis (RX1), and is higher than the first rotation axis (RX1),
wherein one side of the first rotation link (RK1) and one side of the second rotation link (RK2) face each other,
wherein the first rotation axis (RX1) is defined at a portion of the first rotation link (RK1) being adjacent to the one side of the first rotation link (RK1) and a portion of the second rotation link (RK2) being adjacent to the one side of the second rotation link (RK2), respectively, and
wherein the second rotation axis (RX2) is spaced upward apart from each of the first rotator (RT1) and the second rotator (RT2).

10. The electronic device (ED) of any one of claims 1 to 9, wherein each of the first rotator (RT1) and the second rotator (RT2) includes:
a first extension (EX1) extending in the second direction (DR2);
a second extension (EX2) extending from a portion of the first extension (EX1) toward the bracket (BRK) in the first direction (DR1), and in an insertion groove (IG) recessed to an inside of the bracket (BRK) on each of opposite sides of the bracket (BRK) being opposite to each other in the first direction (DR1); and
a protruding support (PSP) protruding upward from an end of the second extension (EX2), and
wherein in a view from the second direction (DR2), an upper surface (US, US') of the first extension (EX1) and an upper surface (US, US') of the second extension (EX2) have a continuously defined slanted surface (SLS), and a height of the slanted surface (SLS) becomes smaller as it goes toward the protruding support (PSP).

11. The electronic device (ED) of claim 10, wherein:
(i) the second extension (EX2) of the first rotator (RT1) and the second extension (EX2) of the second rotator (RT2) are misaligned, and
wherein the guide grooves (GG) are defined on opposite side surfaces of the first extension (EX1) being opposite to each other in the second direction (DR2), respectively; and/or
(ii) the electronic device (ED) further comprises:
a plurality of curved protrusions (PCV) protruding from inner surfaces of the bracket (BRK) facing each other in the second direction (DR2) in the insertion groove (IG), respectively,
wherein the curved protrusions (PCV) are inserted into curved guide grooves (CGG) continuously defined on opposite side surfaces of the protruding support (PSP) being opposite to each other in the second direction (DR2) and opposite side surfaces of the second extension (EX2) being opposite to each other in the second direction (DR2), and
wherein the curved protrusions (PCV) and the curved guide grooves (CGG) overlapping each other are defined as arcs of a circle having a central point as a rotation axis on each of the first rotator (RT1) and the second rotator (RT2).

12. The electronic device (ED) of claim 10 or claim 11, further comprising:
a first wing plate (WPT1) on the bracket (BRK) and the first rotator (RT1), and coupled to an upper side of one side surface (OS) of the first rotator (RT1) facing the first body (BD1) to be rotatable; and
a second wing plate (WPT2) on the bracket (BRK) and the second rotator (RT2), and coupled to an upper side of one side surface (OS') of the second rotator (RT2) facing the second body (BD2) to be rotatable,
wherein in an unfolding state of the display device (DD), one side of the first wing plate (WPT1) and one side of the second wing plate (WPT2) facing each other in the first direction (DR1) are on the protruding supports (PSP) of the first rotator (RT1) and the second rotator (RT2), optionally further comprising:
a fixing bar (FB) connected to the first extension (EX1), spaced upward apart from the first extension (EX1), and extending in the second direction (DR2); and
a dummy protrusion (DPT) protruding from an opposite side of each of the first wing plate (WPT1) and the second wing plate (WPT2) being opposite to the one side of each of the first wing plate (WPT1) and the second wing plate (WPT2),
wherein a seating groove (SG) is defined at each of a portion of an upper surface (US) being adjacent to the one side surface (OS) of the first rotator (RT1) and a portion of an upper surface (US') of the second rotator (RT2) being adjacent to the one side surface (OS') of the second rotator (RT2),
wherein the fixing bar (FB) is on the seating groove (SG), and
wherein the dummy protrusion (DPT) is between the fixing bar (FB) and the seating groove (SG).

13. The electronic device (ED) of claim 12, wherein one side of the first rotation link (RK1) and one side of the second rotation link (RK2) face each other in the first direction (DR1),
a portion of the first rotation link (RK1) being adjacent to the one side of the first rotation link (RK1) and a portion of the second rotation link (RK2) being adjacent to the one side of the second rotation link (RK2) are coupled to the bracket (BRK) to be rotatable, and
wherein the protruding pins (PN) protrude from a portion of the first rotation link (RK1) being adjacent to an opposite side of the first rotation link (RK1) being opposite to the one side of the first rotation link (RK1) and a portion of the second rotation link (RK2) being adjacent to an opposite side of the second rotation link (RK2) being opposite to the one side of the second rotation link (RK2), optionally further comprising:
a first roller (ROL1) coupled to the opposite side of the first rotation link (RK1) to be rotatable; and
a second roller (ROL2) coupled to the opposite side of the second rotation link (RK2) to be rotatable,
wherein the first wing plate (WPT1) and the second wing plate (WPT2) are on the first roller (ROL1) and the second roller (ROL2), respectively,
wherein each of the first roller (ROL1) and the second roller (ROL2) is configured to be rotated around a roller rotation axis (RRX) extending in the second direction (DR2) while overlapping a central point of a circle of each of the first roller (ROL1) and the second roller (ROL2), and
wherein in an unfolding state of the display device (DD), an uppermost end of each of the first roller (ROL1) and the second roller (ROL2) is higher than a portion of the slanted surface (SLS) on the roller rotation axis (RRX).

14. An electronic device (ED) comprising:
a display device (DD);
a first body (BD1) and a second body (BD2) arranged in a first direction (DR1) under the display device (DD);
a bracket (BRK) between the first body (BD1) and the second body (BD2);
a first rotator (RT1) and a second rotator (RT2) between the first body (BD1) and the bracket (BRK) and between the second body (BD2) and the bracket (BRK), respectively, and coupled to the bracket (BRK) to be rotatable;
a first rotation link (RK1) and a second rotation link (RK2) facing the first rotator (RT1) and the second rotator (RT2), respectively, in a second direction (DR2) crossing the first direction (DR1), and coupled to the bracket (BRK) to be rotatable;
a plurality of protruding pins (PN) protruding from the first rotation link (RK1) and the second rotation link (RK2) in the second direction (DR2); and
a plurality of protruding side walls (PSW) protruding from one side of the first body (BD1) and one side of the second body (BD2) facing each other in the first direction (DR1), and facing the first rotation link (RK1) and the second rotation link (RK2) in the second direction (DR2),
wherein the protruding pins (PN) protrude toward the protruding side walls (PSW), and are in guide grooves (GG) defined on surfaces of the protruding side walls (PSW) facing the first rotation link (RK1) and the second rotation link (RK2), and
wherein each of the guide grooves (GG) includes a first guide groove (GG1), and a second guide groove (GG2) extending from the first guide groove (GG1) in another direction.

15. A folding set (FST) comprising:
a first body (BD1) and a second body (BD2) arranged in a first direction (DR1);
a bracket (BRK) between the first body (BD1) and the second body (BD2);
a first rotator (RT1) and a second rotator (RT2) between the first body (BD1) and the bracket (BRK) and between the second body (BD2) and the bracket (BRK), respectively, and coupled to the bracket (BRK) to be rotatable;
a first rotation link (RK1) and a second rotation link (RK2) facing the first rotator (RT1) and the second rotator (RT2), respectively, in a second direction (DR2) crossing the first direction (DR1), and coupled to the bracket (BRK) to be rotatable; and
a plurality of protruding pins (PN) protruding from the first rotation link (RK1) and the second rotation link (RK2) toward the first rotator (RT1) and the second rotator (RT2), respectively, and in guide grooves (GG) defined on surfaces of the first rotator (RT1) and the second rotator (RT2) facing the first rotation link (RK1) and the second rotation link (RK2),
wherein each of the guide grooves (GG) includes:
a first guide groove (GG1) extending in the first direction (DR1); and
a second guide groove (GG2) extending from the first guide groove (GG1) toward a lower side of an inside of the bracket (BRK), and extending to form an angle (θa) of more than 90 degree and less than 180 degrees with respect to the first guide groove (GG1).
